(19) Europäisches Patentamt
European Patent Office
Office européen des brevets

(11) **EP 3 915 782 B1**

(12) **EUROPEAN PATENT SPECIFICATION**

(45) Date of publication and mention
of the grant of the patent:
**17.07.2024 Bulletin 2024/29**

(21) Application number: **20176219.2**

(22) Date of filing: **25.05.2020**

(51) International Patent Classification (IPC):
**B32B 27/08** *(2006.01)* **B32B 27/16** *(2006.01)*
**B32B 27/20** *(2006.01)* **B32B 27/30** *(2006.01)*
**B32B 27/32** *(2006.01)* **H01L 31/049** *(2014.01)*

(52) Cooperative Patent Classification (CPC):
**B32B 27/20; B32B 27/08; B32B 27/16;**
**B32B 27/308; B32B 27/32; H01L 31/049;**
B32B 2250/03; B32B 2250/05; B32B 2250/242;
B32B 2264/102; B32B 2307/20; B32B 2307/30;
B32B 2307/54; B32B 2307/546; B32B 2307/72;

(Cont.)

(54) **LAYER ELEMENT SUITABLE AS INTEGRATED BACKSHEET ELEMENT OF A PHOTOVOLTAIC MODULE**

ALS INTEGRIERTES RÜCKSEITENFOLIENELEMENT EINES FOTOVOLTAIKMODULS GEEIGNETES LAGENELEMENT

ÉLÉMENT DE COUCHE APPROPRIÉ EN TANT QU'ÉLÉMENT DE FEUILLE DE SUPPORT INTÉGRÉE D'UN MODULE PHOTOVOLTAÏQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**01.12.2021 Bulletin 2021/48**

(73) Proprietor: **Borealis AG**
**1020 Vienna (AT)**

(72) Inventors:
• **AARNIO-WINTERHOF, Minna**
**4021 Linz (AT)**
• **YALALOV, Denis**
**444 86 Stenungsund (SE)**
• **DOU, Qizheng**
**4021 Linz (AT)**
• **COSTA, Francis**
**4021 Linz (AT)**
• **ZACH, Markus**
**4021 Linz (AT)**
• **ZINÖCKER, Erich**
**4021 Linz (AT)**

(74) Representative: **Maiwald GmbH**
**Elisenhof**
**Elisenstraße 3**
**80335 München (DE)**

(56) References cited:
**US-A1- 2017 226 321     US-A1- 2017 240 670**
**US-A1- 2019 123 226**

(52) Cooperative Patent Classification (CPC): (Cont.)
B32B 2457/12; Y02E 10/50

**Description**

The present invention relates to a layer element which comprises at least three layers A, B, and C in the configuration A-B-C, an article, preferably a photovoltaic module comprising said layer element as integrated backsheet element, a process for producing said layer element, a process for producing said photovolataic module and the use of said layer element as integrated backsheet element of a photovoltaic module.

**Technical background**

In certain end use applications, like outdoor end use wherein temperature may vary within wide range and articles are may be exposed to sunlight, the polymeric articles have special requirements for instance with respect to mechanical properties, long-term thermal stability, especially at high temperatures, barrier properties and UV stability.
For instance photovoltaic (PV) modules, also known as solar cell modules, produce electricity from light and are used in various kinds of applications, i.a. in outdoor applications, as well known in the field. The type of the photovoltaic module can vary. The modules have typically a multilayer structure, i.e. several different layer elements which have different functions. The layer elements of the photovoltaic module can vary with respect to layer materials and layer structure. The final photovoltaic module can be rigid or flexible. The above exemplified layer elements can be monolayer or multilayer elements. Typically the layer elements of PV module are assembled in order of their functionality and then laminated together to form the HLZ:RW integrated PV module. Moreover, there may be adhesive layer(s) between the layers of an element or between the different layer elements. The photovoltaic (PV) module can for example contain, in a given order, a protective front layer element which can be flexible or rigid (such as a glass layer element), front encapsulation layer element, a photovoltaic element, rear encapsulation layer element, a protective back layer element, which is also called a backsheet layer element and which can be rigid or flexible; and optionally e.g. an aluminium frame. Accordingly, part or all of the layer elements of a PV module, e.g. the front and rear encapsulation layer elements, and often the backsheet layer, are typically of a polymeric material, like ethylene vinyl acetate (EVA) based material, polyester based material or polyamide based material and fluoropolymer based materials.
In case of articles with multilayer element(s) like PV modules the compatibility of the different layer materials may cause problems which can deteriorate the properties of the final article. The properties of the chosen layer materials may also not be sufficient to meet overall property needed for a layer element at end use of the final article. Especially problematic is the compatibility of the rear encapsulation layer element and a polymeric backsheet layer element, which can cause adhesion problems between these layer elements. These adhesion problems are usually solved by including additional adhesive layers between the rear encapsulation layer element and a polymeric backsheet layer element. However, the handling of additional layers increases the complexity of the lamination process which results in increased energy costs and time consumption. It is therefore aimed in the art to reduce the total number of layers in the lamination process of a PV module for reducing the production costs and energy consumption.
WO 2018/141672 discloses an article, suitably a PV module, with a layer element comprising a polyethylene based layer and a polypropylene based layer in adherent contact with each other which can serve as an integrated backsheet of a PV module. Thereby, the polyethylene based layer can serve as the rear encapsulation layer element and polypropylene based layer can serve as the polymeric backsheet layer element. The layer element of WO2018/141672
shows acceptable adhesion between the polyethylene based layer and the polypropylene based layer.
US 2019/0123226 A1 discloses multilayer film structures comprising a layer (B) that comprises a crystalline block copolymer composite (CBC) or a specified block copolymer composite (BC) and a layer C that comprises a polyolefin having at least one melting peak greater than 125°C, the top facial surface of layer C in adhering contact with the bottom facial surface of layer B. Said multilayer film structure preferably comprises a seal layer A having a bottom facial surface in adhering contact with the top facial surface of layer B. Such multilayer film structures are suitable for use in electronic device modules such as photovoltaic modules. WO2018141672 relates to an article comprising a layer element of at least two layers used in photovoltaic (PV) module.
There is still room for improvement in regard of the balance of properties of improved adhesion between the rear encapsulation layer element and a polymeric backsheet layer element and a reduced number of layers in the PV module for reducing the complexity of the lamination process and reducing the production costs and energy consumption.
In the present invention it has surprisingly been found that a layer element comprising three layers A-B-C in which polyethylene based layer A and polypropylene based layer C sandwich an adhesive layer B which comprises an ethylene-alpha-olefin copolymer based composition shows an increased adhesion compared to a two layer structure with the presence of only one additional layer in the layer element which still ensures easy handling and lamination at reduced production costs and energy consumption.

**Summary of the invention**

The present invention relates to a layer element, which comprises layers A, B and C in the configuration A-B-C, wherein

-    layer A comprises a polyethylene composition (PE-A) comprising a copolymer of ethylene, which is selected from

    -    a copolymer of ethylene, which bears silane group(s) containing units (PE-A-a); or
    -    a copolymer of ethylene with polar comonomer unit(s) selected from one or more of $(C_1-C_6)$-alkyl acrylate or $(C_1-C_6)$-alkyl $(C_1-C_6)$-alkylacrylate comonomer unit(s), which additionally bears silane group(s) containing units (PE-A-b),

    whereby, the copolymer of ethylene (PE-A-a) is different from the copolymer of ethylene (PE-A-b);
-    layer B comprises a polyethylene composition (PE-B) comprising a copolymer of ethylene, which is selected from

    -    a copolymer of ethylene and comonomer unit(s) selected from one or more of alpha-olefins having from 3 to 12 carbon atoms (PE-B-a), which has a density of from 850 kg/m$^3$ to 905 kg/m$^3$; or
    -    a copolymer of ethylene and comonomer unit(s) selected from one or more of alpha-olefins having from 3 to 12 carbon atoms, which additionally bears silane group(s) containing units (PE-B-b), and has a density of from 850 kg/m$^3$ to 905 kg/m$^3$; or
    -    a copolymer of ethylene and comonomer unit(s) selected from one or more of alpha-olefins having from 3 to 12 carbon atoms, which additionally which bears functional group containing units originating from at least one unsaturated carboxylic acid and/or its anhydrides, metal salts, esters, amides or imides and mixtures thereof (PE-B-c), and has a density of from 850 kg/m$^3$ to 905 kg/m$^3$; and

-    layer C comprises a polypropylene composition (PP-C) comprising a polymer of propylene (PP-C-a),

wherein layers A and B and layers B and C are in adhering contact with each other.

Further, the invention relates to an article comprising the layer element as described above or below. Said article is preferably a photovoltaic module.

Still further, the invention relates to a process for producing the layer element as described above or below comprising the steps of:

-    adhering the layers A, B and C of the layer element together by extrusion or lamination in the configuration A-B-C; and
-    recovering the formed layer element.

Additionally, the invention relates to a process for producing an article being a photovoltaic (PV) module as described above or below comprising the steps of:

-    assembling the photovoltaic element, the layer element and optional further layer elements to a photovoltaic (PV) module assembly;
-    laminating the layer elements of the photovoltaic (PV) module assembly in elevated temperature to adhere the elements together; and
-    recovering the obtained photovoltaic (PV) module.

Finally, the invention relates to the use of the layer element as described above or below as an integrated backsheet element of a photovoltaic module comprising a photovoltaic element and said layer element, wherein the photovoltaic element is in adhering contact with layer A of the layer element.

**Definitions**

An olefin homopolymer is a polymer which essentially consists of olefin monomer units of one sort. Due to impurities especially during commercial polymerization processes an olefin homopolymer can comprise up to 0.1 mol% comonomer units, preferably up to 0.05 mol% comonomer units and most preferably up to 0.01 mol% comonomer units.

In this sense a propylene homopolymer is a polymer which essentially consists of propylene monomer units and an ethylene homopolymer is a polymer which essentially consists of ethylene monomer units

An olefin copolymer is a polymer which in addition to olefin monomer units also comprise one or more comonomer units in a minor molar amount.

Thereby, a copolymer of propylene comprises a molar majority of propylene monomer units and a copolymer of ethylene comprises a molar majority of ethylene monomer units.

An olefin random copolymer is a copolymer with a molar majority of said olefin monomer units, in which the comonomer units are randomly distributed in the polymeric chain.

A heterophasic polypropylene is a propylene-based copolymer with a crystalline matrix phase, which can be a propylene homopolymer or a random copolymer of propylene and at least one alpha-olefin comonomer, and an elastomeric phase dispersed therein. The elastomeric phase can be a propylene copolymer with a high amount of comonomer which is not randomly distributed in the polymer chain but are distributed in a comonomer-rich block structure and a propylene-rich block structure.

A heterophasic polypropylene usually differentiates from a one-phasic propylene copolymer in that it shows two distinct glass transition temperatures Tg which are attributed to the matrix phase and the elastomeric phase.

A plastomer is a polymer which combines the qualities of elastomers and plastics, such as rubber-like properties with the processing abilities of plastic.

An ethylene-based plastomer is a plastomer with a molar majority of ethylene monomer units. A layer element in the sense of the present invention is a structure of one or more layers with a defined functionality which serves a certain purpose in an article comprising said layer element. In the field of PV modules a layer element is a structure of one or more layers which serves one of several functionalities such as outer protection (i.e. a protective front layer element or protective back layer element), encapsulation of the photovoltaic element (i.e. the front encapsulation layer element or rear encapsulation layer element) and the energy conversion (i.e. the photovoltaic element). A layer element can comprise other components, which are not layers, such as e.g. braces, spacers, frames.

An integrated backsheet element of a PV module is a structure of more than one layers which encompasses more than one functionality of the PV module. It is preferred that the integrated backsheet element encompasses the outer protection functionality of the protective back layer element and the encapsulation of the photovoltaic element function of the rear encapsulation layer element). These functionalities are usually encompassed by different layers of the integrated backsheet element.

Two layers being in adhering contact means that the surface of one layer is in direct contact the surface of the other layer without any layers or any spacers between these layers.

Different in the context of the present invention means that two polymers differ in at least one property or structural element.

## Detailed description

### Layer element

The layer element of the present invention comprises three layers A, B and C in the configuration A-B-C. This means that Layer A is in adhering contact with layer B on one surface of layer B and layer B is in adhering contact with layer C on the other surface of layer B. Thus, layers A and C are not in adhering contact with each other. Instead layers A and C sandwich layer B.

In one embodiment the layer element consists of layers A, B and C in the configuration A-B-C. In said embodiment the layer element is a three-layer element.

In another embodiment the layer element can comprise one or more layer(s) in addition to the layers A, B and C. These additional layers can either be added to the surface of layer A, which is not in adherent contact with layer B (i.e. layer(s) X), or to the surface of layer C, which is not in adherent contact with layer B (i.e. layer(s) Y), or both (layers X and Y).

Possible configurations are X-A-B-C, A-B-C-Y and X-A-B-C-Y.

Layer(s) X can be one or more additional layers, such as 1, 2, 3 or 4 additional layer(s) X, preferably one additional layer X. Layer(s) X can be the same as layer A or different from layer A.

Layer(s) Y can be one or more additional layers, such as 1, 2, 3 or 4 additional layer(s) Y, preferably one additional layer Y. Layer(s) Y can be the same as layer C or different from layer C.

Usually, the layers A and C have the same or a greater thickness than layer B.

In a three-layer element the thickness of layer A is preferably from 30 to 50 % of the total thickness of the three-layer element.

In a three-layer element the thickness of layer B is preferably from 5 to 33.3 % of the total thickness of the three-layer element.

In a three-layer element the thickness of layer C is preferably from 30 to 50 % of the total thickness of the three-layer element.

The thickness ratio of the layers A : B : C in a three-layer element preferably ranges from 45 : 10 : 45 to 33.3 : 33.3 : 33.3.

In a five-layer element the thickness of each layer X, A, B, C, Y preferably is independently from 10 to 30 % of the total thickness of the three-layer element.

The thickness ratio of the layers X : A : B : C : Y in a five-layer element preferably ranges from 20 : 25 : 10 : 25 : 20 to 20 : 20 : 20 : 20 :20.

The layer element usually has a total thickness of from 325 $\mu$m to 2000 $\mu$m, preferably from 450 $\mu$m to 1750 $\mu$m and most preferably from 600 $\mu$m to 1500 $\mu$m.

At least one layer of the layer element may comprise one or more of a filler, pigment, carbon black or flame retardant, as defined below, preferably at least one layer of the layer element comprises one or more of a filler, pigment, carbon black or flame retardant, more preferably at least one or both of layers A and C, preferably at least layer C comprises a pigment or filler, preferably pigment, as defined below.

**Layer A**

Layer A comprises, preferably consists of the polyethylene composition (PE-A).

The polyethylene composition (PE-A) comprises a copolymer of ethylene, which is selected from

- a copolymer of ethylene, which bears silane group(s) containing units (PE-A-a); or
- a copolymer of ethylene with one or more polar comonomer unit(s) selected from $(C_1-C_6)$-alkyl acrylate or $(C_1-C_6)$-alkyl $(C_1-C_6)$-alkylacrylate comonomer unit(s), which additionally bears silane group(s) containing units (PE-A-b),

whereby, the copolymer of ethylene (PE-A-a) is different from the copolymer of ethylene (PE-A-b).

Both alternative copolymers of ethylene (PE-A-a) and (PE-A-b) bear silane group(s) containing units.

The silane group(s) containing units can be present as comonomer units of the copolymer of ethylene or as a compound grafted chemically to the copolymer of ethylene. "Silane group(s) containing comonomer units" means herein above, below or in claims that the silane group(s) containing units are present in the copolymer of ethylene as a comonomer units.

In the case of silane group(s) containing units being incorporated into the copolymer of ethylene as a comonomer units, the silane group(s) containing units are copolymerized as comonomer units with ethylene monomer units during the polymerization process of copolymer of ethylene.

In the case that the silane group(s) containing units are incorporated into the copolymer of ethylene by grafting, the silane group(s) containing units are reacted chemically (also called as grafting), with the copolymer of ethylene after the polymerization of the copolymer of ethylene. The chemical reaction, i.e. grafting, is performed typically using a radical forming agent such as peroxide. Such chemical reaction may take place before or during the lamination process of the invention. In general, copolymerisation and grafting of the silane group(s) containing units to ethylene are well known techniques and well documented in the polymer field and within the skills of a skilled person.

It is also well known that the use of peroxide in the grafting embodiment decreases the melt flow rate (MFR) of an ethylene polymer due to a simultaneous crosslinking reaction. As a result, the grafting embodiment can bring limitation to the choice of the MFR of the copolymer of ethylene as a starting polymer, which choice of MFR can have an adverse impact on the quality of the polymer at the end use application. Furthermore, the by-products formed from peroxide during the grafting process can have an adverse impact on the use of the polyethylene composition (PE-A) at end use application.

The copolymerisation of the silane group(s) containing comonomer units into the polymer backbone provides more uniform incorporation of the units compared to grafting of the units. Moreover, compared to grafting, the copolymerisation does not require the addition of peroxide after the polymer is produced.

Thus, it is preferred that the silane group(s) containing units are present in copolymer of ethylene as a comonomer units. I.e. in case of copolymer of ethylene (PE-A-a) the silane group(s) containing units are copolymerised as comonomer units together with the ethylene monomer units during the polymerisation process of the copolymer of ethylene (PE-A-a).

In the case of the copolymer of ethylene (PE-A-b) the silane group(s) containing units are copolymerised as a comonomer units together with the polar comonomer units and ethylene monomer units during the polymerisation process of the copolymer of ethylene (PE-A-b).

The silane group(s) containing units, preferably the silane group(s) containing comonomer units, of the copolymer of ethylene (PE-A-a) or the copolymer of ethylene (PE-A-b) are preferably a hydrolysable unsaturated silane compound represented by the formula (I):

$$R^1SiR^2{}_qY_{3-q} \qquad (I)$$

wherein

$R^1$ is an ethylenically unsaturated hydrocarbyl, hydrocarbyloxy or (meth)acryloxy hydrocarbyl group,
each $R^2$ is independently an aliphatic saturated hydrocarbyl group,
Y which may be the same or different, is a hydrolysable organic group and
q is 0, 1 or 2;

Further suitable silane group(s) containing comonomer is e.g. gamma-(meth)acryl-oxypropyl trimethoxysilane, gamma(meth)acryloxypropyl triethoxysilane, and vinyl triacetoxysilane, or combinations of two or more thereof.

One suitable subgroup of compound of formula (I) is an unsaturated silane compound or, preferably, comonomer of formula (II)

$$CH_2=CHSi(OA)_3 \qquad (II)$$

wherein each A is independently a hydrocarbyl group having 1-8 carbon atoms, suitably 1-4 carbon atoms.

The silane group(s) containing unit, or preferably, the comonomer, of the invention, is preferably the compound of formula (II) which is vinyl trimethoxysilane, vinyl bismethoxyethoxysilane, vinyl triethoxysilane, more preferably vinyl trimethoxysilane or vinyl triethoxysilane.

The amount of the silane group(s) containing units present in the based on the total amount of monomer units in the the copolymer of ethylene (PE-A-a) or the copolymer of ethylene (PEA-b), preferably as comonomer units, is preferably in the range of from 0.01 to 1.5 mol%, more preferably from 0.01 to 1.00 mol%, still more from 0.05 to 0.80 mol%, even more preferably from 0.10 to 0.60 mol%, most preferably from 0.10 to 0.50 mol%, based on the total amount of monomer units in the the copolymer of ethylene (PE-A-a) or the copolymer of ethylene (PE-A-b).

In one preferred embodiment the copolymer of ethylene is the copolymer of ethylene, which bears silane group(s) containing units (PE-A-a), preferably with silane group(s) containing comonomer units. In this embodiment the copolymer of ethylene (PE-A-a) does not contain, i.e. is without, a polar comonomer as defined for the copolymer of ethylene (PE-A-b). Preferably, the silane group(s) containing comonomer units are the sole comonomer units present in the copolymer of ethylene (PE-A-a). Accordingly, the copolymer of ethylene (PEA-a) is preferably produced by copolymerising ethylene monomer units in a high pressure polymerization process in the presence of silane group(s) containing comonomer units using a radical initiator.

In said preferred embodiment the copolymer of ethylene (PE-A-a) is preferably a copolymer of ethylene with silane group(s) containing comonomer units according to formula (I), more preferably with silane group(s) containing comonomer units according to formula (II), still more preferably with silane group(s) containing comonomer units selected from vinyl trimethoxysilane, vinyl bismethoxyethoxysilane, vinyl triethoxysilane or vinyl trimethoxysilane comonomer. It is especially preferred that the copolymer of ethylene (PE-A-a) is a copolymer of ethylene with vinyl trimethoxysilane or vinyl triethoxysilane comonomer, most preferably a copolymer of ethylene with vinyl trimethoxysilane.

In another preferred embodiment the copolymer of ethylene is copolymer of ethylene with polar comonomer unit(s) selected from one or more, preferably one, of $(C_1-C_6)$-alkyl acrylate or $(C_1-C_6)$-alkyl $(C_1-C_6)$-alkylacrylate comonomer unit(s), which additionally bears silane group(s) containing units (PE-A-b). Preferably, the silane group(s) containing units are present as comonomer units. In this embodiment the copolymer of ethylene (PE-A-b) is thus preferably a copolymer of ethylene with polar comonomer(s) units selected from one or more, preferably one, of $(C_1-C_6)$-alkyl acrylate or $(C_1-C_6)$-alkyl $(C_1-C_6)$-alkylacrylate; and with silane group(s) containing comonomer units. Preferably, the polar comonomer units and the silane group(s) containing comonomer units are the sole comonomer units present in the copolymer of ethylene (PE-A-b). Accordingly, the copolymer of ethylene (PE-A-b) is preferably produced by copolymerising ethylene monomer units in a high pressure polymerization process in the presence of polar comonomer units and silane group(s) containing comonomer units using a radical initiator.

Preferably, the polar comonomer units of the copolymer of ethylene (PE-A-b) are selected from $(C_1-C_6)$-alkyl acrylate comonomer units, more preferably from methyl acrylate (MA), ethyl acrylate (EA) or butyl acrylate (BA) comonomer units, most preferably from methyl acrylate comonomer units.

Without binding to any theory, for instance, methyl acrylate (MA) is the only acrylate which cannot go through the ester pyrolysis reaction, since does not have this reaction path. Therefore, the copolymer of ethylene (PE-A-b) with MA comonomer units does not form any harmful free acid (acrylic acid) degradation products at high temperatures, whereby the copolymer of ethylene (PE-A-b) comprising methyl acrylate comonomer units contributes to good quality and life cycle of the end article thereof. This is not the case e.g. with vinyl acetate units of EVA, since EVA forms harmful acetic acid degradation products at high temperatures. Moreover, the other acrylates like ethyl acrylate (EA) or butyl acrylate (BA) can go through the ester pyrolysis reaction, and if degrade, would form volatile olefinic by-products.

The amount of the polar comonomer units present in the copolymer of ethylene (PE-A-b) is preferably in the range of from 0.5 to 30.0 mol%, preferably from 2.5 to 20.0 mol%, still more preferably from 5.0 to 15.0 mol%, most preferably from 7.5 to 12.5 mol%, based on the total amount of monomer units in the copolymer of ethylene (PE-A-b).

It is preferred that the copolymer of ethylene (PE-A-b) is a copolymer of ethylene with methyl acrylate, ethyl acrylate or butyl acrylate comonomer units and with vinyl trimethoxysilane, vinyl bismethoxyethoxysilane, vinyl triethoxysilane or vinyl trimethoxysilane comonomer units, more preferably with vinyl trimethoxysilane or vinyl triethoxysilane comonomer units.

More preferably the copolymer of ethylene (PE-A-b) is a copolymer of ethylene with methyl acrylate comonomer units and with vinyl trimethoxysilane, vinyl bismethoxyethoxysilane, vinyl triethoxysilane or vinyl trimethoxysilane comonomer, still more preferably a copolymer of ethylene with methyl acrylate comonomer units and with vinyl trimethoxysilane or vinyl triethoxysilane comonomer units, most preferably a copolymer of ethylene with methyl acrylate comonomer units with vinyl trimethoxysilane.

The polyethylene composition (PE-A) enables, if desired, to decrease the melt flow rate (MFR) of the copolymer of ethylene (PE-A-a) or copolymer of ethylene (PE-A-b) compared to prior art and thus offers higher resistance to flow during the production of the layer A and the layer element of the invention. As a result, the preferable MFR can further contribute, if desired, to the quality of the layer element, and to article, preferably the PV module, comprising the layer element.

The melt flow rate, $MFR_2$, of the copolymer of ethylene (PE-A-a) or copolymer of ethylene (PE-A-b) is preferably less than 20 g/10 min, preferably less than 15 g/10 min, more preferably from 0.1 to 13 g/10 min, still more preferably from 0.5 to 10 g/10 min, even more preferably from 1.0 to 8.0 g/10 min, more preferably from 1.5 to 6.0 g/10 min.

The copolymer of ethylene (PE-A-a) or copolymer of ethylene (PE-A-b) preferably has a Shear thinning index, $SHI_{0.05/300}$, of from 30.0 to 100.0, more preferably from 40.0 to 80.0 and most preferably from 50.0 to 75.0.

The preferable SHI range further contributes to the advantageous rheological properties of the polyethylene composition (PE-A).

Accordingly, the combination of the preferable MFR range and the preferable SHI range of the polyethylene composition (PE-A) further contributes to the quality of the layer A and the layer element of the invention. As a result, the preferable MFR can further contribute, if desired, to the quality of the layer element, and to article, preferably PV module, comprising the layer element.

The copolymer of ethylene (PE-A-a) or copolymer of ethylene (PE-A-b) preferably has a melting temperature of from 70 to 120°C, more preferably from 75°C to 110°C, still more preferably from 80°C to 100°C and most preferably from 85°C to 95°C. The preferable melting temperature is beneficial for instance for a lamination process, since the time of the melting/softening step can be reduced.

Preferably the density of the copolymer of ethylene (PE-A-a) or copolymer of ethylene (PEA-b) is from 920 to 960 kg/m$^3$, preferably from 925 to 955 kg/m$^3$ and most preferably from 930 to 950 kg/m$^3$.

The copolymer of ethylene (PE-A-a) or copolymer of ethylene (PE-A-b) can be e.g. commercially available or can be prepared according to or analogously to known polymerization processes described in the chemical literature.

In a preferred embodiment the copolymer of ethylene (PE-A-a) or copolymer of ethylene (PEA-b) is produced by polymerising ethylene suitably with silane group(s) containing comonomer units as defined above, and in case of the copolymer of ethylene (PE-A-b) also with the polar comonomer units as described above, in a high pressure (HP) process using free radical polymerization in the presence of one or more initiator(s) and optionally using a chain transfer agent (CTA) to control the MFR of the polymer.

A suitable high pressure (HP) process with suitable polymerization conditions is described in WO 2018/141672.

Such HP polymerisation results in a so called low density polymer of ethylene (LDPE), herein to copolymer of ethylene (PE-A-a) or copolymer of ethylene (PE-A-b). The term LDPE has a well-known meaning in the polymer field and describes the nature of polyethylene produced in HP, i.e. the typical features, such as different branching architecture, to distinguish the LDPE from PE produced in the presence of an olefin polymerisation catalyst (also known as a coordination catalyst). Although the term LDPE is an abbreviation for low density polyethylene, the term is understood not to limit the density range, but covers the LDPE-like HP polyethylenes with low, medium and higher densities.

The polyethylene composition (PE-A) preferably comprises the copolymer of ethylene (PEA-a) or (PE-A-b) in an amount of from 20.0 wt% to 100 wt%, more preferably from 20.0 wt% to 99.9999 wt%, still more preferably from 65.0 to 99.999 and most preferably from 87.5 wt% to 99.99 wt%, based on the total weight amount of the polyethylene composition (PE-A).

The amount of the copolymer of ethylene (PE-A-a) or (PE-B-b) in the polyethylene composition (PE-A) depends on the presence of additional components in the polyethylene composition (PE-A).

The polyethylene composition (PE-A) suitably comprises additive(s) which are other than filler, pigment, carbon black or flame retardant which terms have a well-known meaning in the prior art.

The optional additives are e.g. conventional additives suitable for the desired end application and within the skills of a skilled person, including without limiting to, preferably at least antioxidant(s), UV light stabilizer(s) and/or UV light absorbers, and may also include metal deactivator(s), clarifier(s), brightener(s), acid scavenger(s), as well as slip agent(s) etc. Each additive can be used e.g. in conventional amounts, the total amount of additives present in the PE composition (PE-A) being preferably as defined below. Such additives are generally commercially available and are described, for example, in "Plastic Additives Handbook", 5th edition, 2001 of Hans Zweifel.

The amount of additives is preferably in the range of from up to 10.0 wt%, such as 0.0001 to 10.0 wt%, more preferably 0.001 and 5.0 wt%, most preferably 0.01 to 2.5 wt%, based on the total weight amount of the polyethylene composition (PE-A).

The polyethylene composition (PE-A) can further comprise fillers, pigments, carbon black and/or flame retardants.

Optional fillers, pigments, carbon black or flame retardants, are typically conventional and commercially available. Suitable optional fillers and pigments are as defined herein in context of the layer C to fillers, pigments. Optional carbon black can be any conventional product suitable for the layer A. Optional flame retardants can be as defined below for the layer C or in claims or e.g. magnesiumhydroxide, ammonium polyphosphate etc.

The amount of fillers, pigments, carbon black and/or flame retardants is preferably in the range of from up to 70.0 wt%, such as 0.1 to 70.0 wt%, preferably 0.5 to 30.0 wt%, most preferably 1.0 to 10.0 wt%, based on the total weight amount of the polyethylene composition (PE-A).

The polyethylene composition (PE-A) can further comprise polymers which are different from the copolymer of ethylene (PE-A-a) or (PE-A-b).

It is however preferred that the polyethylene composition (PE-A) comprises the copolymer of ethylene (PE-A-a) or (PE-A-b) as the only polymeric component(s).

"Polymeric component(s)" exclude herein any carrier polymer(s) of optional additive or filler, pigment, carbon black or flame retardant, e.g. carrier polymer(s) used in master batch(es) of additive or, respectively, filler, pigment, carbon black or flame retardant optionally present in the polyethylene composition (PE-A). Such optional carrier polymer(s) are calculated to the amount of the respective additive or, respectively, pigment or filler based on the amount (100 wt%) of the polyethylene composition (PE-A).

In one embodiment the polyethylene composition (PE-A), comprises, preferably consists of, based on the amount (100 wt%) of the polyethylene composition (PE-A),

- 90.0 to 99.9999 wt%, preferably 95.0 to 99.999 wt%, most preferably 97.5 to 99.99 of the copolymer of ethylene; and
- 0.0001 to 10.0 wt%, preferably 0.001 and 5.0 wt%, most preferably 0.01 and 2.5 wt%, of the additives.

In said embodiment the polyethylene composition (PE-A) usually has the same ranges of the properties of melt flow rate $MFR_2$, density, melting temperature Tm and shear thinning index $SHI_{0.05/300}$ as defined for the copolymer of ethylene (PE-A-a) or copolymer of ethylene (PEA-b) above.

In another embodiment the polyethylene composition (PE-A) comprises in addition to the suitable additives as defined above also one or more of filler, pigment, carbon black or flame retardant. Then the polyethylene composition (PE-A) comprises, preferably consists of, based on the total amount (100 wt%) of the polyethylene composition (PE-A),

- 20.0 to 99.8999 wt%, preferably 65.0 to 99.499 wt%, most preferably 87.5 to 98.99 wt% of the copolymer of ethylene;
- 0.0001 to 10.0 wt%, preferably 0.001 and 5.0 wt%, most preferably 0.01 and 2.5 wt% of the additives; and
- 0.1 to 70.0 wt%, preferably 0.5 to 30.0 wt%, most preferably 1.0 to 10.0 wt% of the one or more of filler, pigment, carbon black or flame retardant.

In still another embodiment the polyethylene composition (PE-A) comprises, preferably consists of, based on the total amount (100 wt%) of the polyethylene composition (PE-A),

- 80.0 to 99.9999 wt% of the copolymer of ethylene;
- 0.0001 to 10.0 wt%, preferably 0.001 and 5.0 wt%, most preferably 0.01 and 2.5 wt% of additives and
- 0 to 20.0 wt%, preferably 0.5 to 15.0 wt%, most preferably 1.0 to 10.0 wt% of one or more of filler or pigment; preferably a pigment.

In said embodiment the polyethylene composition (PE-A) usually has the same ranges of the properties of melt flow rate $MFR_2$ and shear thinning index $SHI_{0.05/300}$ as defined for the copolymer of ethylene (PE-A-a) or copolymer of ethylene (PE-A-b) above.

Preferably the layer A of the layer element consists of the polyethylene composition (PE-A) comprising the copolymer of ethylene as defined above, below or in claims.

The layer A, preferably the polyethylene composition (PE-A), most preferably the copolymer of ethylene is preferably not crosslinked using peroxide.

However, if desired, depending on the end application, the polyethylene composition (PE-A) can be crosslinked via silane group(s) containing units using a silanol condensation catalyst (SCC), which is preferably selected from the group of carboxylates of tin, zinc, iron, lead or cobalt or aromatic organic sulphonic acids, before or during the lamination process of the layer element of the invention. Such SCCs are for instance commercially available.

It is to be understood that the SCC as defined above are those conventionally supplied for the purpose of crosslinking.

The amount of the optional crosslinking agent (SCC), if present, is preferably of 0 to 0.1 mol/kg, like 0.00001 to 0.1, preferably of 0.0001 to 0.01, more preferably 0.0002 to 0.005, more preferably of 0.0005 to 0.005, mol/kg copolymer of ethylene.

Preferably no crosslinking agent (SCC) is present in the layer element (LE).

In a preferred embodiment no silane condensation catalyst (SCC), which is selected from the SCC group of tin-organic catalysts or aromatic organic sulphonic acids, is present in the polyethylene composition (PE-A). In a further preferred embodiment no peroxide or silane condensation catalyst (SCC), as defined above, is present in the polyethylene composition (PE-A).

It is especially preferred that the polyethylene composition is not crosslinked.

As already mentioned, with the polyethylene composition (PE-A) crosslinking of layer A of the layer element can be avoided which contributes to achieve the good quality of the layer element.

Layer A preferably has a thickness of from 100 $\mu$m to 500 $\mu$m, preferably from 150 $\mu$m to 400 $\mu$m, most preferably from 200 $\mu$m to 300 $\mu$m.

**Layer B**

Layer B comprises, preferably consists of the polyethylene composition (PE-B).

The polyethylene composition (PE-B) comprises a copolymer of ethylene, which is selected from

- a copolymer of ethylene and comonomer units selected from one or more of alpha-olefins having from 3 to 12 carbon atoms (PE-B-a), which has a density of from 850 kg/m$^3$ to 905 kg/m$^3$; or
- a copolymer of ethylene and comonomer units selected from one or more of alpha-olefins having from 3 to 12 carbon atoms, which additionally bears silane group(s) containing units (PE-B-b), having a density of from 850 kg/m$^3$ to 905 kg/m$^3$; or
- a copolymer of ethylene and comonomer unit(s) selected from one or more of alpha-olefins having from 3 to 12 carbon atoms, which additionally bears functional group containing units originating from at least one unsaturated carboxylic acid and/or its anhydrides, metal salts, esters, amides or imides and mixtures thereof (PE-B-c), and has a density of from 850 kg/m$^3$ to 905 kg/m$^3$.

All alternative copolymers of ethylene (PE-B-a), (PE-B-b) and (PE-B-c) bear comonomer units selected one or more of alpha olefins having from 3 to 12 carbon atoms.

Suitable alpha-olefins having from 3 to 12 carbon atoms include 1-butene, 1-hexene and 1-octene, preferably 1-butene or 1-octene and more preferably 1-octene. Preferably copolymers of ethylene and 1-octene are used.

The copolymer of ethylene (PE-B-b) differs from the copolymer of ethylene (PE-B-a) in that it additionally bears silane group(s) containing units (PE-B-b).

The silane group(s) containing units are preferably grafted onto the polymeric backbone of the copolymer of ethylene (PE-B-b).

Preferably the silane group(s) containing units of the copolymer of ethylene (PE-B-b) are independently the same as the silane group(s) containing units of the copolymer of ethylene (PE-A-a) or copolymer of ethylene (PE-A-b) above.

Thus, all embodiments and amounts as described above for the silane group(s) containing units of the copolymer of ethylene (PE-A-a) or copolymer of ethylene (PE-A-b) also apply independently for the silane group(s) containing units (PE-B-b) with the exception that the silane group(s) containing units are preferably grafted onto the polymeric backbone of the copolymer of ethylene (PE-B-b).

The copolymer of ethylene (PE-B-b) preferably is a copolymer of ethylene and 1-butene, a copolymer of ethylene and 1-hexene or a copolymer of ethylene and 1-octene onto which silane group(s) containing units are grafted, most preferably a copolymer of ethylene and 1-octene onto which silane group(s) containing units are grafted.

It is especially preferred that the copolymer of ethylene (PE-B-b) preferably is a copolymer of ethylene and 1-butene, a copolymer of ethylene and 1-hexene or a copolymer of ethylene and 1-octene onto which silane group(s) containing units selected from vinyl trimethoxysilane, vinyl bismethoxyethoxysilane, vinyl triethoxysilane, more preferably vinyl trimethoxysilane or vinyl triethoxysilane are grafted, more preferably a copolymer of ethylene and 1-octene onto which silane group(s) containing units selected from vinyl trimethoxysilane, vinyl bismethoxyethoxysilane, vinyl triethoxysilane, more preferably vinyl trimethoxysilane or vinyl triethoxysilane are grafted.

Most preferred is a copolymer of ethylene and 1-octene onto which vinyl trimethoxysilane is grafted.

The copolymer of ethylene (PE-B-a) preferably is a copolymer of ethylene and 1-butene, a copolymer of ethylene and 1-hexene or a copolymer of ethylene and 1-octene, most preferably a copolymer of ethylene and 1-octene.

The copolymer of ethylene (PE-B-c) differs from the copolymer of ethylene (PE-B-a) in that it additionally bears functional group containing units originating from at least one unsaturated carboxylic acid and/or its anhydrides, metal salts, esters, amides or imides and mixtures thereof (PE-B-c).

The functional groups containing units are preferably grafted onto the polymeric backbone of the copolymer of ethylene (PE-B-c).

The functional groups containing units preferably originate from a compound selected from the group consisting of maleic anhydride, acrylic acid, methacrylic acid, crotonic acid, fumaric acid, fumaric acid anhydride, maleic acid, citraconic acid and mixtures thereof, preferably originating from maleic anhydride.

The amount of the functional groups containing units present in the based on the total amount of monomer units in the copolymer of ethylene (PE-B-c) is preferably in the range of from 0.01 to 1.5 mol%, more preferably from 0.01 to 1.00 mol%, still more from 0.02 to 0.80 mol%, even more preferably from 0.02 to 0.60 mol%, most preferably from 0.03 to 0.50 mol%, based on the total amount of monomer units in the copolymer of ethylene (PE-B-c).

The copolymer of ethylene (PE-B-c) preferably is a copolymer of ethylene and 1-butene, a copolymer of ethylene and 1-hexene or a copolymer of ethylene and 1-octene onto which functional groups containing units are grafted, most preferably a copolymer of ethylene and 1-octene onto which functional groups containing units are grafted.

It is especially preferred that the copolymer of ethylene (PE-B-c) preferably is a copolymer of ethylene and 1-butene, a copolymer of ethylene and 1-hexene or a copolymer of ethylene and 1-octene onto which functional groups containing units originating from maleic anhydride, acrylic acid, methacrylic acid, crotonic acid, fumaric acid, fumaric acid anhydride, maleic acid, citraconic acid and mixtures thereof, more preferably maleic anhydride, are grafted, more preferably a copolymer of ethylene and 1-octene onto which functional groups containing units originating from maleic anhydride, acrylic acid, methacrylic acid, crotonic acid, fumaric acid, fumaric acid anhydride, maleic acid, citraconic acid and mixtures thereof, most preferably maleic anhydride, are grafted.

In a preferred embodiment the polyethylene composition (PE-B) comprises a copolymer of ethylene, which is selected from

- a copolymer of ethylene and comonomer units selected from one or more of alpha-olefins having from 3 to 12 carbon atoms (PE-B-a), which has a density of from 850 kg/m$^3$ to 905 kg/m$^3$; or
- a copolymer of ethylene and comonomer units selected from one or more of alpha-olefins having from 3 to 12 carbon atoms, which additionally bears silane group(s) containing units (PE-B-b), having a density of from 850 kg/m$^3$ to 905 kg/m$^3$.

The following properties characterize all alternative copolymers of ethylene (PE-B-a), (PE-B-b) and (PE-B-c): The copolymer of ethylene is preferably an ethylene based plastomer.

The copolymer of ethylene has a density in the range of from 850 to 905 kg/m$^3$, preferably in the range of from 855 to 900 kg/m$^3$, more preferably in the range of from 860 to 895 kg/m$^3$, most preferably in the range of from 865 to 890 kg/m$^3$.

The MFR$_2$ of the copolymer of ethylene is preferably less than 20 g/min, more preferably less than 15 g/10 min, even more preferably from 0.1 to 13 g/10 min, still more preferably from 0.5 to 10 g/10 min, most preferably from 0.8 to 8.0 g/10 min.

The melting temperature of the copolymer of ethylene is preferably below 130°C, preferably below 120°C, more preferably below 110°C and most preferably below 100°C.

Furthermore the copolymer of ethylene preferably has a glass transition temperature Tg (measured with DMTA according to ISO 6721-7) of below -25°C, preferably below -30°C, more preferably below -35°C.

The copolymer of ethylene preferably has an ethylene content from 55.0 to 95.0 wt%, preferably from 60.0 to 90.0 wt% and more preferably from 65.0 to 88.0 wt%.

The molecular mass distribution Mw/Mn of the copolymer of ethylene is most often below 4.0, such as 3.8 or below, but is at least 1.7. It is preferably between 3.5 and 1.8.

The copolymer of ethylene can be any copolymer of ethylene having the above defined properties, which are commercially available, i.a. from Borealis under the tradename Queo, from DOW under the tradename Engage or Affinity, or from Mitsui under the tradename Tafmer.

Alternately copolymer of ethylene can be prepared by known processes, in a one stage or two stage polymerization process, comprising solution polymerization, slurry polymerization, gas phase polymerization or combinations therefrom, in the presence of suitable catalysts, like vanadium oxide catalysts or single-site catalysts, e.g. metallocene or constrained geometry catalysts, known to the art skilled persons.

Suitable polymerization processes are described in WO 2019/134904.

The polyethylene composition (PE-B) preferably comprises the copolymer of ethylene (PE-B-a), (PE-B-b) or (PE-B-c) in an amount of from 30.0 wt% to 100 wt%, more preferably from 30.0 wt% to 99.9999 wt%, still more preferably from 40.0 wt% to 99.999 wt% and most preferably from 50.0 wt% to 99.99 wt%, based on the total weight amount of the polyethylene composition (PE-B).

The amount of the copolymer of ethylene (PE-B-a), (PE-B-b) or (PE-B-c) in the polyethylene composition (PE-B) depends on the additional components in the polyethylene composition (PE-B).

The polyethylene composition (PE-B) suitably comprises additive(s) which are other than filler, pigment, carbon black or flame retardant which terms have a well-known meaning in the prior art.

The optional additives are preferably independently selected from the list of additives and in the amounts as described above for the polyethylene composition (PE-A).

The polyethylene composition (PE-B) can further comprise pigments, carbon black and/or flame retardants.

Optional pigments, carbon black or flame retardants, are preferably independently selected from the pigments, carbon black or flame retardants as described above for the polyethylene composition (PE-A) wit reference to the lists described for layer C.

The amount of pigments, carbon black and/or flame retardants is preferably in the range of from up to 40.0 wt%, such as 0.1 to 40.0 wt%, preferably 0.5 to 30.0 wt%, most preferably 1.0 to 15.0 wt%, based on the total weight amount of the polyethylene composition (PE-B).

The polyethylene composition (PE-B) can further comprise polymers, which are different from the copolymer of ethylene (PE-B-a), (PE-B-b) or (PE-B-c).

Said optional polymers are preferably selected from propylene based polymers or ethylene based polymers or mixtures thereof.

The optional propylene based polymers are preferably selected from propylene-alpha-olefin random copolymers and heterophasic copolymers of propylene or mixtures thereof.

The optional ethylene based polymers are preferably selected from ethylene-alpha-olefin copolymers or mixtures thereof.

The amount of polymers different from the copolymer of ethylene (PE-B-a), (PE-B-b) or (PE-B-c) is preferably in the range of from up to 60.0 wt%, such as 2.0 to 60.0 wt%, preferably 5.0 to 50.0 wt%, most preferably 10 to 40.0 wt%, based on the total weight amount of the polyethylene composition (PE-B).

The polyethylene composition (PE-B) is preferably free of fillers as defined above or below for layers A and C.

In one embodiment, the polyethylene composition (PE-B), comprises, preferably consists of, based on the amount (100 wt %) of the polyethylene composition (PE-B),

- 90.0 to 99.9999 wt%, preferably 95.0 to 99.999 wt%, most preferably 97.5 to 99.99 wt% of the copolymer of ethylene; and
- 0.0001 to 10.0 wt%, preferably 0.001 and 5.0 wt%, most preferably 0.01 and 2.5 wt%, of the additives.

In said embodiment the polyethylene composition (PE-B) usually has the same ranges of the properties of melt flow rate $MFR_2$, density, melting temperature Tm and glass transition temperature Tg as defined for the copolymer of ethylene (PE-B-a), (PE-B-b) or (PE-B-c) above.

In another embodiment the polyethylene composition (PE-B) comprises in addition to the suitable additives as defined above also one or more of pigment, carbon black or flame retardant as defined above. Then the polyethylene composition (PE-B) comprises, preferably consists of, based on the total amount (100 wt%) of the polyethylene composition (PE-B),

- 40.0 to 99.8999 wt%, preferably 65.0 to 99.499 wt%, most preferably 87.5 to 98.99 wt% of the copolymer of ethylene;
- 0.0001 to 10.0 wt%, preferably 0.001 and 5.0 wt%, most preferably 0.01 and 2.5 wt% of the additives; and
- 0.1 to 40.0 wt%, preferably 0.5 to 30.0 wt%, most preferably 1.0 to 15.0 wt% of the one or more of pigment, carbon black or flame retardant.

In still another embodiment, the polyethylene composition (PE-B) comprises additives as defined above also one or more polymer different to the copolymer of ethylene (PE-B-a), (PE-B-b) or (PE-B-c) as defined above. Then the polyethylene composition (PE-B) comprises, preferably consists of, based on the total amount (100 wt%) of the polyethylene composition (PE-B),

- 40.0 to 99.8999 wt%, preferably 50.0 to 99.0 wt%, most preferably 60.0 to 98.5 wt% of the copolymer of ethylene;
- 0.0001 to 10.0 wt%, preferably 0.001 and 5.0 wt%, most preferably 0.01 and 2.5 wt% of the additives; and
- 2.0 to 60.0 wt%, preferably 5.0 to 50.0 wt%, most preferably 10.0 to 40.0 wt% of the one or more different polymer.

In yet another embodiment, the polyethylene composition (PE-B) comprises in addition to the suitable additives as defined above also one or more polymer different to the copolymer of ethylene (PE-B-a), (PE-B-b) or (PE-B-c) and one or more of pigment, carbon black or flame retardant as defined above. Then the polyethylene composition (PE-B)

comprises, preferably consists of, based on the total amount (100 wt%) of the polyethylene composition (PE-B),

- 30.0 to 99.8999 wt%, preferably 40.0 to 99.0 wt%, most preferably 50.0 to 98.5 wt% of the copolymer of ethylene;
- 0.0001 to 10.0 wt%, preferably 0.001 and 5.0 wt%, most preferably 0.01 and 2.5 wt% of the additives;
- 2.0 to 60.0 wt%, preferably 5.0 to 50.0 wt%, most preferably 10.0 to 40.0 wt% of the one or more different polymer and
- 0.1 to 40.0 wt%, preferably 0.5 to 30.0 wt%, most preferably 1.0 to 15.0 wt% of the one or more of pigment, carbon black or flame retardant.

In the presence of one or more different polymer the properties of the polyethylene composition (PE-B) usually are influenced not only by the properties of the copolymer of ethylene but also by the properties of the one or more different polymer. Thus, the properties of the polyethylene composition can differ from those of the copolymer of ethylene (PE-B-a), (PE-B-b) or (PE-B-c).

Preferably the layer B of the layer element consists of the polyethylene composition (PE-B) comprising the copolymer of ethylene as defined above, below or in claims.

Layer B preferably has a thickness of from 50 $\mu$m to 500 $\mu$m, preferably from 75 $\mu$m to 400 $\mu$m, most preferably from 100 $\mu$m to 300 $\mu$m.

**Layer C**

Layer C comprises, preferably consists of the polypropylene composition (PP-C).

The polypropylene composition (PP-C) comprises a polymer of propylene (PP-C-a).

The polymer of propylene (PP-C-a) can be a single polymer of propylene or a mixture of two or more different polymers of propylene.

The polymer of propylene (PP-C-a) can be a homopolymer or copolymer of propylene.

Preferably the polymer of propylene (PP-C-a) is at least a copolymer of propylene. More preferably the polymer of propylene (PP-C-a) is at least one, preferably one heterophasic copolymer of propylene which comprises, preferably consists of,

a polypropylene matrix component and
an elastomeric propylene copolymer component which is dispersed in said polypropylene matrix; or
a mixture of two or more, e.g. two such heterophasic copolymers of propylene which are different.

The heterophasic copolymer of propylene preferably as one or more of the following properties:

- Melting temperature Tm of at least 145°C, preferably from 155 to 175°C, most preferably from 160 to 170°C;
- Vicat softening temperature Vicat A of at least 90°C, preferably from 105 to 165°C, most preferably from 110 to 155°C;
- Melt flow rate MFR$_2$ of 1.0 to 20.0 g/10 min, preferably from 2.0 to 18 g/10 min, preferably from 3.0 to 15.0 g/10 min;
- Xylene cold soluble (XCS) fraction in amount of from 5 to 40 wt%, preferably from 10 to 35 wt%;
- Comonomer content of 2.0.0 to 20.0 wt%, preferably of 3.0 to 18 wt%;
- Flexural modulus of at least 600 MPa, preferably of 750 to 2500 MPa; and/or
- Density of 900 to 910 kg/m$^3$.

It is preferred that the heterophasic copolymer of propylene has all of the above cited properties.

It is preferred that the polypropylene composition (PP-C) comprises

- 5 to 50 wt% of a heterophasic copolymer of propylene (PP-C-a) which has a Melting temperature (Tm) of at least 145°C, when measured as described below under the Determination methods, and a Vicat softening temperature (Vicat A) of at least 90°C, and which comprises a polypropylene matrix component (a1) and an elastomeric propylene copolymer component (a2) which is dispersed in said polypropylene matrix (a1), and
- 20 to 60 wt% of a heterophasic copolymer of propylene (PP-C-b) which has a Melting temperature (Tm) of at least 145°C, when measured as described below under the Determination methods, and a Vicat softening temperature (Vicat A) of at least 90°C, and which comprises a polypropylene matrix component (b1) and an elastomeric propylene copolymer component (b2) which is dispersed in said polypropylene matrix (b1),
- 10 to 40 wt% of an inorganic filler,
- 0 to 35 wt% of a pigment
- 0 to 30 wt% of an plastomer, and
- 0.3 to 5 wt% of an additive(s) other than the inorganic filler,

based on the total amount (100 wt%) of the polypropylene composition;
wherein the amount of xylene cold soluble (XCS) fraction of heterophasic copolymer of propylene (PP-C-b) is higher than the amount of xylene cold soluble (XCS) fraction of heterophasic copolymer of propylene (PP-C-a).

The polypropylene matrix component of the heterophasic copolymer of propylene (PP-C-a) can be a propylene homopolymer component or a propylene random copolymer component, preferably a propylene homopolymer component.

The heterophasic copolymer of propylene (PP-C-a) preferably has one or more, more preferably all of the following properties:

- MFR$_2$ of 0.2 to 15.0 g/10 min, more preferably of 0.5 to 10 g /10 min, most preferably of 1.0 to 7.0 g/10 min,,
- Xylene cold soluble (XCS) fraction in amount of 3 to 30 wt%, more preferably of 5 to 25 wt%, still more preferably 5 to 20 wt%, most preferably 8 to 17 wt%,
- Comonomer content of 0.5 to 20 wt%, more preferably of 1.0 to 20 wt%, still more preferably of 1.2 to 10 wt%, even more preferably of 2.0 to 10 wt%, most preferably of 2.0 to 8.0 wt%, whereby it is preferred that the comonomer(s) is selected from ethylene and/or C4-C8 alpha olefin comonomers, more preferably from ethylene,
- Melting temperature, Tm, of 158 to 170°C, more preferably of 160 to 170°C, still preferably of 163 to 170°C, most preferably of 163 to 167°C,
- Flexural modulus of at least 900 MPa, more preferably of 950 to 3000 MPa, still more preferably of 1000 to 2400 MPa, even more preferably of 1100 to 2300 MPa, most preferably of 1200 to 2200 MPa,
- Density of 900 to 910 kg/m$^3$, and/or
- Vicat softening temperature (Vicat A) of at least 100°C, more preferably of 130 to 200°C, still more preferably 145 to 165°C, most preferably of 148 to 165°C.

In a preferred embodiment, the heterophasic copolymer of propylene (PP-C-a) meets all of the above described properties of comonomer content, Tm, Vicat A, MFR$_2$, XCS fraction, flexural modulus and density.

The polypropylene matrix component of the heterophasic copolymer of propylene (PP-C-b) can be a propylene homopolymer component or a propylene random copolymer component, preferably a propylene homopolymer component.

The heterophasic copolymer of propylene (PP-C-b) preferably has one or more, more preferably all of the following properties:

- MFR$_2$ of 3.0 to 25.0 g/10 min, more preferably of 5.0 to 20 g /10 min, most preferably of 7.0 to 18 g/10 min,
- Xylene cold soluble (XCS) fraction in amount of 10 to 60 wt%, more preferably of 15 to 50 wt%, still more preferably 15 to 40 wt%, most preferably 20 to 37 wt%,
- Comonomer content of 5.0 to 35 wt%, more preferably of 5.0 to 30 wt%, still more preferably of 7.0 to 25 wt%, most preferably of 10 to 20 wt%, whereby it is preferred that the comonomer(s) is selected from ethylene and/or C4-C8 alpha olefin comonomers, more preferably from ethylene,
- Melting temperature, Tm, of 158 to 170°C, more preferably of 160 to 170°C, most preferably of 163 to 167°C,
- Flexural modulus of less than 1000 MPa, more preferably of 300 to 950 MPa, still more preferably of 400 to 900 MPa, even more preferably of 500 to 900 MPa, most preferably of 550 to 850 MPa, ,
- Density of 900 to 910 kg/m$^3$, and/or
- Vicat softening temperature (Vicat A) of at least 90°C, more preferably of 100 to 200°C, still more preferably 105 to 150°C, most preferably of 110 to 145°C.

According to still another preferred embodiment the polypropylene composition (PP-C) comprises

- 5 to 50 wt% of a heterophasic copolymer of propylene (PP-C-a) which has a Melting temperature (Tm) of at least 145°C (DSC), when measured as described below under the Determination methods, and a Vicat softening temperature (Vicat A) of at least 90°C (according to ASTM D 1525, method A, 50°C/h, 10N), and which comprises a polypropylene matrix component (a1) and an elastomeric propylene copolymer component (a2) which is dispersed in said polypropylene matrix (a1), and
- 20 to 60 wt% of a heterophasic copolymer of propylene (PP-C-b) which has a Melting temperature (Tm) of at least 145°C (DSC), when measured as described below under the Determination methods, and a Vicat softening temperature (Vicat A) of at least 90°C (according to ASTM D 1525, method A, 50°C/h, 10N), and which comprises a polypropylene matrix component (b1) and an elastomeric propylene copolymer component (b2) which is dispersed in said polypropylene matrix (b1),
- 5 to 30 wt% of an inorganic filler,

- 0 to 35 wt% of a pigment
- 0 to 30 wt% of an plastomer, and
- 0.3 to 5 wt% of an additive(s) other than the inorganic filler,

based on the total amount (100 wt%) of the polypropylene composition;
wherein the amount of xylene cold soluble (XCS) fraction of heterophasic copolymer of propylene (PP-C-b) is higher than the amount of xylene cold soluble (XCS) fraction of heterophasic copolymer of propylene (PP-C-a).

In a preferred embodiment, the heterophasic copolymer of propylene (PP-C-b) meets all of the above described properties of comonomer content, Tm, Vicat A, $MFR_2$, XCS fraction, flexural modulus and density.

The heterophasic copolymer of propylene (PP-C-b) usually differs from the heterophasic copolymer of propylene (PP-C-a) in a higher amount of xylene cold soluble (XCS) fraction.

It is further preferred that the heterophasic copolymer of propylene (PP-C-b) has a higher $MFR_2$ than the heterophasic copolymer of propylene (PP-C-a).

Still further, the heterophasic copolymer of propylene (PP-C-b) preferably has a higher amount of elastomeric phase than the heterophasic copolymer of propylene (PP-C-a). Additionally, the heterophasic copolymer of propylene (PP-C-b) preferably has a higher comonomer content than the heterophasic copolymer of propylene (PP-C-a).

Further, the heterophasic copolymer of propylene (PP-C-b) preferably has a lower flexural modulus than the heterophasic copolymer of propylene (PP-C-a).

The polymer of propylene (PP-C-a), preferably the heterophasic copolymer of propylene can be a commercially available grade or can be produced e.g. by conventional polymerisation processes and process conditions using e.g. the conventional catalyst system known in the literature.

The polymer of propylene (PP-C-a), preferably the heterophasic copolymer of propylene as described herein, can be polymerized in a sequential polymerization process, such as a multistage process.

A suitable process is described in WO 2017/071847.

A preferred multistage process is a "loop-gas phase"-process, such as developed by Borealis A/S, Denmark (known as BORSTAR® technology) described e.g. in patent literature, such as in EP 0 887 379, WO 92/12182 WO 2004/000899, WO 2004/111095, WO 99/24478, WO 99/24479 or in WO 00/68315.

A further suitable slurry-gas phase process is the Spheripol® process of LyondellBasell.

After the polymer of propylene (PP-C-a) has been removed from the last polymerisation stage, it is preferably subjected to process steps for removing the residual hydrocarbons from the polymer. Such processes are well known in the art and can include pressure reduction steps, purging steps, stripping steps, extraction steps and so on. Also combinations of different steps are possible. After the removal of residual hydrocarbons the heterophasic copolymer of propylene is preferably mixed with additives as it is well known in the art. Such additives are described above for the polypropylene composition (PP-C). The polymer particles are then extruded to pellets as it is known in the art. Preferably co-rotating twin screw extruder is used for the extrusion step. Such extruders are manufactured, for instance, by Coperion (Werner & Pfleiderer) and Japan Steel Works.

The polymer of propylene (PP-C-a) is preferably produced by polymerisation using any suitable Ziegler-Natta type. Typical suitable Ziegler-Natta type catalyst is stereospecific, solid high yield Ziegler-Natta catalyst component comprising as essential components Mg, Ti and Cl. In addition to the solid catalyst a cocatalyst(s) as well external donor(s) are typically used in polymerisation process.

Components of catalyst may be supported on a particulate support, such as inorganic oxide, like silica or alumina, or, usually, the magnesium halide may form the solid support. It is also possible that catalysts components are not supported on an external support, but catalyst is prepared by emulsion-solidification method or by precipitation method.

Alternatively the polymer of propylene (PP-C-a) of the invention can be produced using a modified catalyst system as described below.

More preferably, a vinyl compound of the formula (I) is used for the modification of the catalyst:

$$CH_2=CH-CHR^1R^2 \qquad (IV)$$

wherein $R^1$ and $R^2$ together form a 5- or 6-membered saturated, unsaturated or aromatic ring, optionally containing substituents, or independently represent an alkyl group comprising 1 to 4 carbon atoms, whereby in case $R^1$ and $R^2$ form an aromatic ring, the hydrogen atom of the - $CHR^1R^2$ moiety is not present.

More preferably, the vinyl compound (IV) is selected from: vinyl cycloalkane, preferably vinyl cyclohexane (VCH), vinyl cyclopentane, 3-methyl-1-butene polymer and vinyl-2-methyl cyclohexane polymer. Most preferably the vinyl compound (IV) is vinyl cyclohexane (VCH) polymer.

The solid catalyst usually also comprises an electron donor (internal electron donor) and optionally aluminium.

Suitable internal electron donors are, among others, esters of carboxylic acids or dicarboxylic acids, like phthalates, maleates, benzoates, citraconates, and succinates, 1,3-diethers or oxygen or nitrogen containing silicon compounds. In addition mixtures of donors can be used.

The cocatalyst typically comprises an aluminium alkyl compound. The aluminium alkyl compound is preferably trialkyl aluminium such as trimethylaluminium, triethylaluminium, tri-isobutylaluminium or tri-n-octylaluminium. However, it may also be an alkylaluminium halide, such as diethylaluminium chloride, dimethylaluminium chloride and ethylaluminium sesquichloride.

Suitable external electron donors used in polymerisation are well known in the art and include ethers, ketones, amines, alcohols, phenols, phosphines and silanes. Silane type external donors are typically organosilane compounds containing Si-OCOR, Si-OR, or $Si-NR_2$ bonds, having silicon as the central atom, and R is an alkyl, alkenyl, aryl, arylalkyl or cycloalkyl with 1-20 carbon atoms are known in the art.

Examples of suitable catalysts and compounds in catalysts are shown in among others, in WO 87/07620, WO 92/21705, WO 93/11165, WO 93/11166, WO 93/19100, WO 97/36939, WO 98/12234, WO 99/33842, WO 03/000756, WO 03/000757, WO 03/000754, WO 03/000755, WO 2004/029112, EP 2610271, WO 2012/007430. WO 92/19659, WO 92/19653, WO 92/19658, US 4382019, US 4435550, US 4465782, US 4473660, US 4560671, US 5539067, US5618771, EP45975, EP45976, EP45977, WO 95/32994, US 4107414, US 4186107, US 4226963, US 4347160, US 4472524, US 4522930, US 4530912, US 4532313, US 4657882, US 4581342, US 4657882.

The polypropylene composition (PP-C) preferably comprises additives.

Herein the term additives exclude the optional filler(s), optional pigment(s) and optional flame retardant(s). Such additives are preferably conventional and commercially available, including without limiting to, UV stabilisers, antioxidants, nucleating agents, clarifiers, brighteners, acid scavengers, as well as slip agents, processing aids etc. Such additives are generally commercially available and are described, for example, in "Plastic Additives Handbook", 5th edition, 2001 of Hans Zweifel.

Each additive can be used e.g. in conventional amounts. The suitable additives and the amounts thereof for layer C can be chosen by a skilled person depending on the desired article and the end use thereof.

Preferably, the additives are selected at least from UV stabiliser(s) comprising hindered amine compound and antioxidant(s) comprising a dialkyl amine compound. More preferably the additives are selected at least from UV stabiliser(s) comprising hindered amine compound and antioxidant(s) comprising a dialkyl amine compound, and wherein the additives are without phenolic unit(s). The expression "the additives are without phenolic unit(s)" means herein that any additive compound including UV stabiliser(s) and antioxidant(s) present in the polypropylene composition (PP-C) bears no phenolic units. Preferably the composition does not comprise any components, like additives, with phenolic units.

Accordingly, herein the filler(s), pigment(s) and flame retardant(s) are not understood nor defined as the additives.

Preferably the polypropylene composition (PP-C) comprises at least one or both of the groups of additives and/or one or more selected from filler(s), pigment(s) and flame retardant(s).

The optional filler(s), if present, are preferably inorganic filler(s), more preferably one inorganic filler. The particle size and/or aspect ratio of the filler can vary as well-known by a skilled person. Preferably, the filler(s) is selected from one or more of wollastonite, talc or glass fiber. Such filler products are commercial products with varying particle size and/or aspect ratio and can be chosen by a skilled person depending on the desired end article and end application. The filler(s) can be e.g. conventional and commercially available. The amount of the filler(s), if present, is preferably 10 to 40 wt%, preferably 15 to 30 wt%, based on the total amount (100 wt%) of the polypropylene composition (PP-C).

The optional pigment(s), if present, is preferably selected from the list of wollastonite, mica, titanium dioxide $TiO_2$, talc, CaCO3, dolomite.

It is preferred that the pigment is a white pigment. White pigment is preferably $TiO_2$. Such pigments are well known and e.g. available as commercial $TiO_2$ pigment, also referred herein as $TiO_2$. Any carrier medium, e.g. carrier polymer, is calculated to the amount of the pigment. The amount of the pigment, if present, is preferably 2 to 35 wt%, preferably 3 to 30 wt%, preferably 5 to 25 wt%, based on the total amount of the polypropylene composition (PP-C). It shall be noted that wollastonite and talc can act both as filler and as pigment. In their function as pigment they are usually present in an amount of from 2 to less than 15 wt%, preferably from 3 to 10 wt%, based on the total amount of the polypropylene composition (PP-C). In their function as filler they are usually present in an amount of from 15 to 40 wt%, preferably from 20 to 30 wt%, based on the total amount of the polypropylene composition (PP-C).

The optional flame retardant(s), if present, can be e.g. any commercial flame retardant product, preferably a flame retardant comprising inorganic phosphorous. The amount of the flame retardant(s), if present, is preferably of 1 to 20 wt%, preferably 2 to 15 wt%, more preferably 3 to 12 wt%, based on the amount of the polypropylene composition (PP-C).

Any optional carrier polymers of additives, of optional filler(s), of optional pigment(s) and of optional flame retardant(s), e.g. master batches of said components, together with the carrier polymer, are calculated to the amount of the respective component, based on the amount (100 %) of the polypropylene composition (PP-C).

In one embodiment the PP composition comprises at least pigment(s).

The optional further polymer component(s) can be any polymer other than polymer of propylene (PP-C-a), preferably a polyolefin based polymer. Typical examples of further polymer component(s) are one or both of a plastomer or functionalised polymer which both have a well-known meaning.

The optional plastomer, if present, is preferably a copolymer of ethylene with at least one C3 to C10 alpha-olefin. The plastomer, if present, has preferably one or all, preferably all, of the below properties

- a density of 850 to 915, preferably 860 to 910, $kg/m^3$,
- $MFR_2$ of 0.1 to 50, preferably 0.2 to 40 g/10min (190°C, 2.16kg), and/or
- the alpha-olefin comonomer is octene.

The optional plastomer, if present, is preferably produced using a metallocene catalyst, which term has a well-known meaning in the prior art. The suitable plastomers are commercially available, e.g. plastomer products under tradename QUEO™, supplied by Borealis, or Engage™ , supplied by ExxonMobil, Lucene supplied by LG, or Tafmer supplied by Mitsui. If present, then the amount of the optional plastomer is lower than the amount of the polymer of propylene (PP-C-a).

The optional functionalised polymer, if present, is a polymer which is functionalised e.g. by grafting. For instance, polar functional groups, such as maleic anhydride (MAH), can be grafted to a polyolefin to form functional polymers thereof. The polymer of propylene (PP-C-a), preferably the two heterophasic copolymers of propylene (PP-C-a) and (PP-C-b), is/are different from optional functionalised polymer. The polymer of propylene (PP-C-a), preferably the two heterophasic copolymers of propylene (PP-C-a) and (PP-C-b), is/are without grafted functional units. I.e. the term polymer of propylene (PP-C-a), preferably the two heterophasic copolymers of propylene (PP-C-a) and (PP-C-b), excludes the polymers of propylene grafted with functional groups. The amount of the optional functionalised polymer, if present, is preferably of 3 to 30 wt%, preferably 3 to 20 wt%, preferably 3 to 18 wt%, more preferably 4 to 15 wt%, based on the amount of the polypropylene composition (PP-C). If present, then the amount of the optional functionalised polymer(s) is less than the amount of the polymer of propylene (PP-C-a), preferably the amount of the two heterophasic copolymers of propylene (PP-C-a) and (PP-C-b).

The polypropylene composition (PP-C) preferably comprises

- 5 to 50 wt%, more preferably 10 to 40 wt%, still more preferably 15 to 35 wt%, most preferably 20 to 33 wt% of the heterophasic copolymer of propylene (PP-C-a),
- 25 to 70 wt%, more preferably 30 to 70 wt%, still more preferably 35 to 65 wt%, most preferably 35 to 45 wt% of the heterophasic copolymer of propylene (PP-C-b),
- 10 to 40 wt%, more preferably 10 to 35 wt%, still more preferably 15 to 30 wt%, most preferably 17 to 30 wt% of the inorganic filler,
- 0 to 35 wt% of a pigment,
- 0 to 30 wt% of the plastomer, and
- 0.3 to 5.0 wt%, more preferably 0.5 to 3.0 wt% of additives, which preferably comprise at least an antioxidant(s) and UV-stabiliser(s);

based on the total amount (100 wt%) of the polypropylene composition.

In case the polypropylene composition (PP-C) comprises a plastomer, then the amount of the plastomer is preferably 3 to 20, more preferably 4 to 17, more preferably 4 to 15, wt%, based on the total amount (100 wt%) of the polypropylene composition (PP-C).

The polypropylene composition (PP-C) preferably has an $MFR_2$ (230 °C, 2.16 kg) of 1.0 to 25.0 /10 min, more preferably of 2.0 to 20 /10 min, still more preferably of 3.0 to 15 g/10 min, most preferably of 4.0 to 10 g/10 min.

The polypropylene composition (PP-C) of the invention preferably has a xylene cold soluble (XCS) content in amount of 10 to 40 wt%, more preferably 15 to 35 wt%, most preferably 15 to 30 wt%, based on the total amount of the polypropylene composition (PP-C).

The polypropylene composition (PP-C) preferably has a Vicat softening temperature (Vicat A) of 110 to 155°C, more preferably of 110 to 150°C, still most preferably of 120 to 150°C.

The polypropylene composition (PP-C) preferably has a tensile modulus of at least 900 MPa, more preferably of 900 to 3000 MPa, still more preferably of 1000 to 2700 MPa, most preferably of 1200 to 2500 MPa.

The polypropylene composition (PP-C) preferably has a tensile strain at break of 100 to 700%, more preferably of 100 to 600%, most preferably of 100 to 500%.

The polypropylene composition (PP-C) preferably has a tensile modulus at least 800 MPa, more preferably of 850 to 2000 MPa, when measured in machine direction from 200 $\mu$m monolayer cast film.

The polypropylene composition (PP-C) preferably has a tensile strain at break of 100 to 700%, more preferably of at least 620%, more preferably of 630 to 1500%, most preferably of 650 to 1200 %, when measured from 200 $\mu$m monolayer cast film.

The obtained polymer of propylene (PP-C-a), preferably the two heterophasic copolymers of propylene (PP-C-a) and (PP-C-b), is/are then compounded together with the additives and one or more of optional components as described above in a known manner. The compounding can be effected in a conventional extruder e.g. as described above and the obtained melt mix is produced to an article or, preferably, pelletised before used for the end application. Part or all of the additives or optional components may be added during the compounding step.

**Process for producing the layer element**

The invention further provides a process for producing the layer element as defined above or below wherein the process comprises a step of:

- adhering the layers A, B and C of the layer element together by extrusion or lamination in the configuration A-B-C; and
- recovering the formed layer element.

In one embodiment the layers A, B and C of layer element are produced by extrusion, preferably by coextrusion.

The term "extrusion" means herein that the at least two layers of the layer element can be extruded in separate steps or in a same extrusion step, as well known in the art. One and preferable embodiment of the "extrusion" process for producing the at least three layers of the layer element is a coextrusion process. The term "coextrusion" means herein that the at least two layers, preferably at least the three layers A, B and C of the layer element can be coextruded in a same extrusion step, as well known in the art. The term "coextrusion" means herein that, in addition to said at least three layers A, B and C, also all or part of the additional layers of the layer element as described above, if present, can be formed simultaneously using one or more extrusion heads.

The extrusion and preferable coextrusion step can be carried out for example using a blown film or cast film extrusion process. Both processes have a well-known meaning and are well described in the literature of the field of the art.

Moreover, the extrusion step and the preferable coextrusion step, can be effected in any conventional film extruder, preferably in a conventional cast film extruder, e.g. in a single or twin screw extruder. Extruder equipments, like cast film extruder equipments, are well described in the literature and commercially available.

Other suitable extrusion techniques suitable for producing the layer element of the present invention are e.g. blown-film extrusion, such as blow-film coextrusion, and an extrusion process, such as a cast film extrusion process, preferably a cast film coextrusion process, with a subsequent calendaring process. These techniques are well known in the art.

The extrusion conditions are depend on the chosen layer materials and can be chosen by a skilled person.

Preferably the extrusion, preferably the coextrusion, of the layer element, is carried by cast film extrusion, preferably by cast film coextrusion.

In extrusion embodiment, in case of an adhesive layer between the adhering sides of the first and second layer, the adhesive layer is typically extruded or coextruded during the extrusion step of the first and second layer.

Part or all of said optional additional layer(s) of the layer element can be extruded, like coextruded, on the side of the layer A or the layer C, or on the side of both the layer A and C, opposite to side(s) which is in adhering contact with the layer B. The extrusion of said optional additional layer(s) can be carried out during the extrusion, preferably during the coextrusion, step layer A and layer C. Alternatively or additionally, part or all of said optional additional layer(s) can be laminated to said opposite side of one or both of layer A and layer C after the extrusion, preferably coextrusion, step of layers A, B and C.

In an alternative embodiment, the layer element is produced by laminating at least two of the layers A, B and C to an adhering contact. The lamination is carried out in a conventional lamination process using conventional lamination equipment well known in the art. In a typical lamination process, the separately formed layers of the layer element are arranged to form of the layer element assembly; then said layer element assembly is subjected to a heating step typically in a lamination chamber at evacuating conditions; after that said layer element assembly is subjected to a pressing step to build and keep pressure on the layer element assembly at the heated conditions for the lamination of the assembly to occur; and subsequently the layer element is subjected to a recovering step to cool and remove the obtained layer element.

Similarly in the alternative lamination embodiment, in addition to the layer A, B and C, the layer element may comprise further layer(s) on side opposite to adhering side of one or both of layers A and C. In that case part or all of said optional additional layer(s) of the layer element can be laminated and/or extruded on the side of layer A or C, or on the side of both the layers A and C, opposite to side which is in adhering contact with the layer B. Extrusion of optional additional layer(s) can be done before the lamination step of at least two of layers A, B and C. The lamination of optional additional layer(s) can be carried, in a step preceding the lamination step of at least two of layers A, B and C, during the lamination step of at least two of layers A, B and C, or after the lamination step of at least two of layers A, B and C.

In the alternative embodiment, wherein at least two of layers A, B and C is produced by lamination, then layer B is applied using known techniques either on the surface of the layer A or on the surface of the layer C.

The formed layer element can be further treated, if desired, for instance to improve the adhesion of the layer element or to modify the outer surfaces of the layer element. For example, the outer sides (opposite to "adhering" sides) of the layers A and C, or in case of producing the layer element by lamination, then also the "adhering" sides of the layer which are laminated, can be surface treated using conventional techniques and equipments which are well-known for a skilled person.

The most preferred process for producing the layer element of the invention is said extrusion process, preferably said coextrusion process. More preferably, the extrusion process for producing the layer element is a cast film extrusion, most preferably a cast film coextrusion process.

Accordingly, the preferred process for producing the layer element of the invention is an extrusion process, preferably a coextrusion process, which comprises the steps of:

- mixing in separate mixing devices, preferably meltmixing in separate extruders, the polyethylene composition (PE-A) of layer A, the polyethylene composition (PE-B) of layer B and, respectively, the polypropylene composition (PP-C) of layer C;
- applying, preferably applying simultaneously, the melt mix of the polyethylene composition (PE-A) of layer A, the polyethylene composition (PE-B) of layer B and, respectively, the polypropylene composition (PP-C) of layer C via a die to form a layer element of at least layers A, B and C in the configuration A-B-C, wherein said Layer A and B and layers B and C are in adhering contact to each other;
- recovering the obtained layer element.

As well known a meltmix of the polymer composition or component(s) thereof is applied to form a layer. Meltmixing means herein mixing above the melting or softening point of at least the major polymer component(s) of the obtained mixture and is carried out for example, without limiting to, in a temperature of at least 10-15°C above the melting or softening point of polymer component(s). The mixing step can be carried out in an extruder, like film extruder, e.g. in cast film extruder. The meltmixing step may comprise a separate mixing step in a separate mixer, e.g. kneader, arranged in connection and preceding the extruder of the layer element production line. Mixing in the preceding separate mixer can be carried out by mixing with or without external heating (heating with an external source) of the component(s).

In the above preferable process, the extrusion process is preferably a cast film extrusion, preferably a cast film coextrusion process. The extrusion process can also be a blown film extrusion process, preferably a blown film coextrusion process, or an extrusion process, such as a cast film extrusion process, preferably a cast film coextrusion process, with a subsequent calendaring process.

As said the extrusion process for forming the layer element of the invention can also comprise a further step subsequent to the extrusion, e.g. a further treatment step or lamination step, preferably subsequent to the extrusion step as described above.

**Article**

The article comprising the layer element can be any article wherein the properties of the layer element of the invention are for instance desirable or feasible.

The layer element can be part of an article or form the article, like film.

As non-limiting examples of such articles, extruded articles or moulded articles or combinations thereof can be mentioned. For instance the molded articles can be for packaging (including boxes, cases, containers, bottles etc), for household applications, for parts of vehicles, for construction and for electronic devices of any type. Extruded articles can be e.g. films of different types for any purposes, like plastic bags or packages, e.g. wrappers, shrink films etc.; electronic devices of any type; pipes which comprise the layer element. The combinations of molded and extruded article are e.g. molded containers or bottles comprising an extruded label which comprises the layer element.

In one embodiment the article is a multilayer film comprising, preferably consisting of, the layer element. In this embodiment the layer element of the article is preferably a film for various end applications e.g. for packaging applications without limiting thereto. In this invention the term "film" covers also thicker sheet structures e.g. for thermoforming.

In a second embodiment the article is an assembly comprising two or more layer elements, wherein at least one layer element is the layer element of the invention. The further layer element(s) of the assembly can be different or same as the layer element of the invention. The second embodiment is the preferable embodiment of the invention.

The assembly of the preferable second embodiment is preferably a photovoltaic (PV) module comprising a photovoltaic element and one or more further layer elements, wherein at least one layer element is the layer element of the invention.

The preferred photovoltaic (PV) module of the invention comprises, in the given order, a protective front layer element, preferably a glass layer element, a front encapsulation layer element, a photovoltaic element, and the layer element (LE) of the invention.

In this preferable embodiment the layer element of the invention is multifunctional, i.e. the layer element of the invention functions both as a rear encapsulation layer element and as the protective back layer element. More preferably, layer A functions as an encapsulation layer element and layer C functions as the protective back layer element which is also called herein as backsheet layer element. Layer B functions as adhesive layer in order to improve adhesion between the encapsulation layer element and the protective back layer element. Naturally, as said above under "Layer element (LE) of the invention", there may be additional layers attached to the outer surface of Layer A to enhance the "encapsulation layer element" functionality. Further naturally, there may be additional layers attached to the outer surface of the layer C to enhance the "protective back layer element" functionality. Such additional layers can be introduced to layer A and, respectively, to layer C by extrusion, like coextrusion, or by lamination, or by combination thereof, in any order.

In the preferred photovoltaic (PV) module of the invention, the side of layer A opposite to side adhering to layer B is preferably in adhering contact with a photovoltaic element of the PV module.

Moreover, the side of layer C opposite to side adhering to layer B can be in adhering contact with further layers or layer elements, as known in the art of backsheet layer elements of PV module.

The final photovoltaic module can be rigid or flexible.

Moreover, the final PV module of the invention can for instance be arranged to a metal, such as aluminum, frame.

All said terms have a well-known meaning in the art.

The materials of the above elements of the above elements other than the layer element of the invention are well known in the prior art and can be chosen by a skilled person depending on the desired PV module.

The above exemplified layer elements other than the layer element of the invention can be monolayer or multilayer elements. Moreover, said other layer elements or part of the layers thereof can be produced by extrusion, e.g. coextrusion, by lamination, or by a combination of extrusion and lamination, in any order, depending on the desired end application, as well known in the art.

The "photovoltaic element" means that the element has photovoltaic activity. The photovoltaic element can be e.g. an element of photovoltaic cell(s), which has a well-known meaning in the art. Silicon based material, e.g. crystalline silicon, is a non-limiting example of materials used in photovoltaic cell(s). Crystalline silicon material can vary with respect to crystallinity and crystal size, as well known to a skilled person. Alternatively, the photovoltaic element can be a substrate layer on one surface of which a further layer or deposit with photovoltaic activity is subjected, for example a glass layer, wherein on one side thereof an ink material with photovoltaic activity is printed, or a substrate layer on one side thereof a material with photovoltaic activity is deposited. For instance, in well-known thin film solutions of photovoltaic elements e.g. an ink with photovoltaic activity is printed on one side of a substrate, which is typically a glass substrate.

The photovoltaic element is most preferably an element of photovoltaic cell(s). "Photovoltaic cell(s)" means herein a layer element(s) of photovoltaic cells, as explained above, together with connectors.

The detailed description given above for layer element of the invention applies to layer element present in an article, preferable in a photovoltaic module.

In some embodiments of the PV module there can also be an adhesive layer between the different layer elements and/or between the layers of a multilayer element, as well known in the art. Such adhesive layers have the function to improve the adhesion between the two elements and have a well-known meaning in the lamination field. The adhesive layers are differentiated from the other functional layer elements of the PV module, e.g. those as specified above, below or in claims, as evident for a skilled person in the art.

Preferably, there is no adhesive layer between the photovoltaic element and the front encapsulation layer element. Alternatively, preferably there is no adhesive layer between the photovoltaic layer element and the layer element of the invention. More preferably, there is no adhesive layer between the photovoltaic element and the front encapsulation layer element and there is no adhesive layer between the photovoltaic layer element and the layer element of the invention.

As well-known in the PV field, the thickness of the above mentioned elements, as well as any additional elements, of an article, preferably of a laminated photovoltaic module, of the invention can vary depending on the desired end use application, like the desired photovoltaic module embodiment, and can be chosen accordingly by a person skilled in the PV field.

As a non-limiting example only, the thickness of a photovoltaic element, e.g. an element of monocrystalline photovoltaic cell(s), is typically between 100 to 500 microns.

The thickness of layer A of the layer element of the photovoltaic (PV) module of the invention, which preferably functions as a rear encapsulation layer element, can naturally vary depending on the desired PV module, as evident for a skilled person. Usually, the thickness of layer A is as defined above. The thickness of the rear encapsulation layer element which in addition to layer A can comprise further layer(s) X, can typically be up to 2 mm, preferably up to 1 mm, typically 0.15 to 0.6 mm, when layer(s) X are present. As said, naturally, the thickness depends on the desired final end application and can be chosen by a skilled person.

Similarly, the thickness of the layer C of the layer element, which preferably functions as a protective back layer element (backsheet element) or part of such protective back layer element of the photovoltaic (PV) module of the invention, is usually as defined above together. The thickness of the protective back layer element, which in addition to layer C can comprise further layer(s) Y, can naturally vary depending on the desired PV module application, as evident for a skilled person. As an example only, the thickness of protective back layer element of the preferable PV module can typically be up to 2 mm, preferably up to 1 mm, typically 0.15 to 0.6 mm, when layer(s) Y are present. Naturally, as said, the thickness depends on the desired final end application and can be chosen by a skilled person.

The layer element of the article, preferably of the photovoltaic module, can be produced as described above for the layer element of the invention.

The separate further elements of PV module other than the layer element of the invention can be produced in a manner well known in the photovoltaic field or are commercially available.

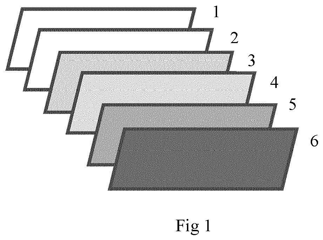

Figure 1 is a schematic picture of a typical PV module of the invention comprising a protective front layer element (1), a front encapsulation layer element (2), a photovoltaic element (3) and the layer element of the invention (combination of (4)+(5)+(6)), showing layers A, B and C, wherein layer A functions as a rear encapsulation layer element (4) and layer C as a protective back layer element (6) with layer B functioning as adhesive layer (5).

**Process for preparing a photovoltaic module**

The invention further provides a process for producing an assembly of the invention wherein the process comprises the steps of:

- assembling the layer element of the invention and further layer element(s) to an assembly;
- laminating the elements of the assembly in elevated temperature to adhere the elements together; and
- recovering the obtained assembly.

The layer elements can be provided separately to the assembling step. Or, alternatively, part of the layer elements or part of the layers of two layer elements can be adhered together, i.e. integrated, already before providing to the assembling step.

The preferred process for producing the assembly is a process for producing a photovoltaic (PV) module by

- assembling the photovoltaic element, the layer element of the invention and optional further layer elements to a photovoltaic (PV) module assembly;
- laminating the layer elements of the photovoltaic (PV) module assembly in elevated temperature to adhere the elements together; and
- recovering the obtained photovoltaic (PV) module.

The conventional conditions and conventional equipment are well known and described in the art of the photovoltaic module and can be chosen by a skilled person.

As said part of the layer elements can be in integrated form, i.e. two or more of said PV elements can be integrated together, e.g. by lamination, before subjecting to the lamination process of the invention.

Preferable embodiment of the process for forming the preferable photovoltaic (PV) module of the invention, is a lamination process comprising,

- an assembling step to arrange a photovoltaic element and the layer element of the invention to form of a multilayer assembly, wherein layer A of the layer element is arranged in contact with the photovoltaic element, preferably an assembling step to arrange, in a given order, a front protective layer element, a front encapsulating layer element, a photovoltaic element and the layer element of the invention to form of a multilayer assembly, wherein layer A of the layer element is arranged in contact with a photovoltaic element;
- a heating step to heat up the formed PV module assembly optionally, and preferably, in a chamber at evacuating conditions;
- a pressing step to build and keep pressure on the PV module assembly at the heated conditions for the lamination of the assembly to occur; and
- a recovering step to cool and remove the obtained PV module comprising the layer element.

The lamination process is carried out in laminator equipment, which can be e.g. any conventional laminator which is suitable for the multilaminate to be laminated, e.g. laminators conventionally used in the PV module production. The choice of the laminator is within the skills of a skilled person. Typically, the laminator comprises a chamber wherein the heating, optional, and preferable, evacuation, pressing and recovering (including cooling) steps take place.

**Use**

The use of the layer element according to the invention as defined above or below as an integrated backsheet element of a photovoltaic module comprising a photovoltaic element and said layer element, wherein the photovoltaic element is in adhering contact with layer A of the layer element.

Thereby, the layer element and the photovoltaic module preferably includes as the properties and definitions of the layer element and the photovoltaic module as described above or below.

**Determination Methods**

Melt Flow Rate: The melt flow rate (MFR) is determined according to ISO 1133 and is indicated in g/10 min. The MFR is an indication of the flowability, and hence the processability, of the polymer. The higher the melt flow rate, the lower the viscosity of the polymer. The $MFR_2$ of polypropylene is measured at a temperature 230 °C and a load of 2.16 kg. The $MFR_2$ of polyethylene is measured at a temperature 190 °C and a load of 2.16 kg.

Density: ISO 1183, measured on compression moulded plaques.

Comonomer contents:

- The content (wt% and mol%) of polar comonomer present in the copolymer of ethylene (PE-A-b) and the content (wt% and mol%) of silane group(s) containing units present in the copolymers of ethylene (PE-A-a), (PE-A-b) and (PE-B-b) was determined as described in WO 2018/141672 for the content (wt% and mol%) of polar comonomer present in the polymer (a) and the content (wt% and mol%) of silane group(s) containing units (preferably comonomer) present in the polymer (a).
- The alpha-olefin comonomer content present in copolymer of ethylene (PE-B-a), (PE-B-b) and (PE-B-c) was determined as described in WO 2019/134904 for the comonomer content quantification of poly(ethylene-co-1-octene) copolymers.
- The comonomer content present in propylene polymer (PP-C-a) was determined as described in WO 2017/071847 for the comonomer content measurement.

Rheological properties:

Dynamic Shear Measurements (frequency sweep measurements)

The rheological properties are measured as described in WO 2018/141672.

Melting temperature ($T_m$) and heat of fusion (Hf) were measured as described in WO 2018/141672.

Xylene cold soluble (XCS) was measured as described in WO 2018/141672.

Vicat softening temperature was measured according to ASTM D 1525 method A (50°C/h, 10N).

Tensile Modulus; Tensile stress at yield and Tensile strain at break were measured as described in WO 2018/141672.

Flexural modulus was measured as described in WO 2017/071847.

Interlayer adhesion of co-extruded films and laminates:

To test the adhesive bond of co-extruded films, double laminates were produced. Two co-extruded films, encapsulant sides facing inside and a Teflon stripe in-between to enable starting point for peeling, were laminated together. The vacuum lamination occurred at 150°C using a lamination program of 5 minutes evacuation time, followed by 15 minutes pressing time with an upper chamber pressure of 800 mbar.

Interlayer adhesion of co-extruded/laminated sheets:

The adhesive bond forces of co-extruded/double-laminated sheets were tested on a universal testing machine (Zwick Z010) based on modified methods of ISO 11339.

5 specimens (length: approx. 200mm / width: 25 mm) were prepared (cut) from each sample in machine direction.

A teflon stripe was removed, and the separated layers were mounted between two pneumatic clamps and the force required to pull the layers apart and displacement was measured.

If peeling **&** yielding occurred parallel, the elongating layer was cut apart, to enable pure peeling between weakest interlayer.

Average peeling force (unit: N) and type/point of failure were recorded.

In some cases no peeling occurred, but the co-extruded film only yielded.

The peeling results were divided into categories: "low" corresponding average peeling forces <10N, "high" for results 30N, and "very high" for results >60N.

**Test parameters:**

    Clamping distance: 10 mm
    Pre-load: 10 N
    Speed pre-load: 50 mm/min
    Pre- **&** Postmeasurement travel: 20 mm
    Measurement travel (incl. Pre- & Postmeasurement travel): 100 mm
    Test speed: 50 mm/min

Power output measurement

Current-voltage (IV) characteristics of the 1-cell modules were obtained using a HALM cetisPV-Celltest3 flash tester. Prior to the measurements, the system was calibrated using a reference cell with known IV response. The 1-cell modules were flashed using a 30 ms light pulse from a xenon source. All results from the IV-measurements were automatically converted to standard test conditions (STC) at 25°C by the software PV Control, available from HALM. Every sample setup was flashed three times on both sides of the bifacial module and given IV parameters are calculated average values of these three individual measurements. All modules were flash tested with a black mask when flashed from the front side. No mask was used when flashed from the rear side. The black mask was made out of standard black coloured paper and had a square-shaped opening of 160*160 mm. During flash test, the black mask was positioned in such way that the solar cell in the solar module was totally exposed to the flash pulse, and that there was 2mm gap between the solar cell edges and the black mask. The black mask was fixated to the modules by using tape. All IV-characterization were done in accordance with the IEC 60904 series.

The retained Pmax is determined according to IEC 60904. Pmax is the power that the PV module generates from a flash pulse of 1000 W/m2 at standard test conditions (STC). From the IV-curve generated at the flash test, Pmax is obtained from the equation below where Isc is the short-circuit current, Voc is the open-circuit voltage and FF is the fill factor.

$$P_{max} = V_{oc} * I_{sc} * FF$$

EL imaging

To the solar mini-module placed in a dark room a current is fed and the emitted light is detected using NIKON D5200 camera with the selected f-number f/5, exposure time 20 sec and ISO speed 3200.

Damp heat test (DH)

The damp heat (DH) test was performed for the PV minimodules of the invention. The DH test was performed in climate chamber at 85°C temperature and relative humidity of 85% according to IEC 61215 for 2000h. Afterwards optical inspection, EL imaging and power output tests were performed to rate the PV minimodules.

Thermal cycling test (TCT) for PV minimodules

The PV minimodules were put into Thermal Cycling test. The samples are put into climate chamber between temperatures of -40°C to 85°C, according to IEC 61215. 50 cycles a week are done following the guidelines given in the standard. In total the mimimodules were treated with 250 cycles in the climate chamber. Afterwards optical inspection, EL imaging and power output tests were performed to rate the PV minimodules.

Thermal cycling test (TCT)

An additional test program was performed for a backsheet layer alone to evaluate the durability of the composition. 250 $\mu$m mono films were produced. Small holes were pressed with cutting tools in MD, TD and in 45° direction to give a starting point for the crack propagation. Afterwards laminates with glass, EVA encapsulant and a monolayer backsheet film of the inventive compositions were produced to evaluate the performance. The samples are put into a climate chamber at temperatures between -40°C to 85°C, according to IEC 61215. 50 cycles a week are done following the guidelines given in the standard. In total the laminates were treated with 200 cycles in the climate chamber. Afterwards visual inspection was performed to evaluate possible crack propagation.

**Experimental part**

**Preparation of the polyethylene compositions (PE-A) for layer A**

The copolymer of ethylene (PE-A-b) was produced in a commercial high pressure tubular reactor at a pressure 2500-3000 bar and max temperature 250-300 °C using conventional peroxide initiatior. Ethylene monomer, methyl acrylate (MA) polar comonomer and vinyl trimethoxy silane (VTMS) comonomer (silane group(s) containing comonomer) were added to the reactor system in a conventional manner. CTA was used to regulate MFR as well known for a skilled person. After having the information of the property balance desired for the inventive final polymer (a), the skilled person can control the process to obtain the copolymer of ethylene (PE-A-b).
The amount of the vinyl trimethoxy silane units, VTMS, (=silane group(s) containing units), the amount of MA and $MFR_2$ are given in the table 1.
The properties in below tables were measured from the polymer (a) as obtained from the reactor or from a layer sample as indicated below.

Table 1: Properties of copolymer of ethylene (PE-A-b) obtained from the reactor

| Test polymer | copolymer of ethyene (PE-A-b) |
|---|---|
| $MFR_{2,16}$, g/10 min | 3.5 |
| Methyl acrylate (MA) content, mol% (wt%) | 8.8 (22.5) |
| Melt Temperature, °C | 91 |
| VTMS content, mol% (wt%) | 0.3 (1.4) |
| Density, kg/m$^3$ | 948 |
| SHI (0.05/300), 150°C | 70 |

In above table 1 MA denotes the content of methyl mcrylate comonomer units present in the polymer and, respectively, VTMS content denotes the content of vinyl trimethoxy silane comonomer units present in the polymer.
The copolymer of ethylene (PE-A-b) was compounded in conventional amounts with conventional antioxidant (CAS number 32687-78-8) and UV-stabilising hindered amine compound (CAS number 71878-19-8, 70624-18-9 (in US)) to produce the polyethylene composition (PE-A) for layer A.

Polyethylene composition 1 (PE-A-1) consists of the stabilized polyethylene composition (PE-A-b) described above.

Polyethylene composition 1 (PE-A-2) consists of 90 wt% of the stabilized polyethylene composition (PE-A-b) described above and 10 wt% of a $TiO_2$ masterbatch, which includes 65 wt% of $TiO_2$.

**Preparation of the polyethylene compositions (PE-B) for layer B**

Polyethylene composition 1 (PE-B-1) consists of Queo7007LA, which is an ethylene-based plastomer with 1-octene comonomer units having a melt flow rate $MFR_2$ (190°C, 2.16 kg) of 6.5 g/10 min and a density of 870 kg/m$^3$ (including stabilizers), commercially available from Borealis AG.
Polyethylene composition 2 (PE-B-2) consists of Queo7007LA, which is grafted with 1 wt% vinyl trimethoxy silane units (VTMS). The grafting is performed as described in the example section of WO 2019/201934.
Polyethylene composition 3 (PE-B-3) consists of Queo7001LA, which is an ethylene-based plastomer with 1-octene comonomer units having a melt flow rate $MFR_2$ (190°C, 2.16 kg) of 1.0 g/10 min and a density of 870 kg/m$^3$

(including stabilizers), commercially available from Borealis AG.

**Preparation of the polypropylene compositions (PE-C) for layer C**

For polypropylene composition (PP-C-1) the composition as described in example IE6 of WO 2017/071847 has been used.

The polypropylene composition thus includes

| | |
|---|---|
| 40.7 wt% | heterophasic propylene copolymer B, |
| 27.2 wt% | heterophasic propylene copolymer A, (both prepared as described in the example section of WO 2017/071847) |
| 23 wt% | talc, |
| 8 wt% | Queo 8230, supplier Borealis, is an ethylene based octene plastomer, produced in a solution polymerisation process using a metallocene catalyst, $MFR_2$ (190°C) of 30 g/10 min and density of 882 $kg/m^3$, and |
| 1.1 wt% | additives as described in the example section of WO 2017/071847. |

For polypropylene composition (PP-C-2), in addition to the additives added for polypropylene composition (PP-C-1) the following pigments were added during the melt homogenisation step:
7 wt% of a $TiO_2$ masterbatch, which includes 70 wt% of $TiO_2$.

The polypropylene composition (PP-C-1) has the following properties as listed in Table 3. The tensile properties tensile modulus, tensile strength and tensile strain at break were measured using a 200 $\mu$m monolayer cast film in MD direction

Table 3: Properties of the polypropylene composition (PP-C-1)

| | PP-C-1 |
|---|---|
| MFR [g/10 min] | 5.5 |
| XCS [wt%] | 23 |
| Tensile modulus, MD [MPa] | 1408 |
| Tensile strength [MPa] | 26 |
| Tensile strain at break [%] | 956 |

Since polypropylene composition (PP-C-2) only differs from (PP-C-1) in the presence of a TiOz masterbatch the same properties as for (PP-C-1) are to be expected.

**Preparation of the layer elements**

Layer A was produced from the polyethylene compositions (PE-A-1) and (PE-A-2). Layer B was produced from the polyethylene compositions (PE-B-1), (PE-B-2) and (PE-B-3). Layer C was produced from the polypropylene compositions (PP-C-1) and (PP-C-2).

3-layer calendar films for the inventive layer elements of examples IE1-IE5 and one 2-layer cast film for the comparative layer element of comparative example CE1 were prepared on a Dr. Collin cast film line consisting of 3 automatically controlled extruders, a chill roll unit, a take-off unit with a cutting station and three winders to wrap the film and edge strips.

Each layer was extruded with an individual extruder: Two outer layers (layer A and layer C) were extruded with extruders equipped with 25mm screw with LD of 30. The core layer (layer B) was extruded with extruder equipped with 30mm screw with LD of 30. The thickness of each layer A and B was 225 $\mu$m and for each layer C was 250 $\mu$m resulting in a film thickness of the inventive examples IE1-IE5 of 700 $\mu$m and a film thickness of the comparative example CE1 of 475 $\mu$m.

The layer A were extruded onto the embossed side of the calendar-unit and the layers C were extruded onto the smooth side of the calendar-unit with the layers B, were present, sandwiched by layers A and C. The die is fixed at an angle of 90° to the extruders and extrude onto the chill roll. The melt will be extruded between a roll gap of two steel rolls, which is pre-adjusted by a feeler gauge to a gap of ~600 micron before starting up the line. One roll is textured with a pyramid embossing structure (layer A side) and the other one is polished standard chill roll (Layer C side). The rolls are pressed against each other with a hydraulic pressure of 75 bar to transfer the structure to the film. The chill roll is cooled to 25 °C. The melt temperature was 140-190 °C for polyethylene compositions (PE-A) and (PE-B) and 210-215 °C for the polypropylene compositions PP-C. Each extruder was run at a throughput of 5~20 kg/h. The die width is 300 mm.

The following layer elements were coextruded as listed in Table 4:

Table 4: Coextruded layer elements

|     | Layer A | Layer B | Layer C |
|-----|---------|---------|---------|
| CE1 | PE-A-1  | ---     | PP-C-1  |
| IE1 | PE-A-1  | PE-B-1  | PP-C-1  |
| IE2 | PE-A-1  | PE-B-2  | PP-C-1  |
| IE3 | PE-A-1  | PE-B-3  | PP-C-1  |
| IE4 | PE-A-2  | PE-B-1  | PP-C-1  |
| IE5 | PE-A-2  | PE-B-1  | PP-C-2  |

**Preparation of laminates**

A double laminate of each example layer element LE were produced: LE / LE, with layers A facing each other and Teflon stripe at one end of the laminate, to give the starting point for the following peeling test. A type of T-peeling tests were performed on 25 mm wide stripes, with 10 N pre-load and 50 mm/min test speed. Results are reported in Table 5 below. Average peeling force, $F_{AVG}$ were reported in following way: "Low" values being <10N compares to peeling by hand (weak), and "High" corresponding values > 30N, and "very high" corresponding values >60N are considered as strong adhesion. If no result was given, no peeling was observed.

Table 5: T-peeling test results on IBS double laminates before and after 1000h DH.

| Laminate | $F_{AVG}$ | Peeling behavior | $F_{AVG}$ (after 1000h DH) | Peeling behaviour (after 1000h DH) |
|----------|-----------|------------------|----------------------------|-------------------------------------|
| CE1 | Low | between layers A and C | Low | between layers A and C |
| IE1 | - | yielding of laminate | Very high | mixed through all layers |
| IE2 | Very high | between layers B and C | High | mixed through all layers |
| IE3 | Very high | between layers B and C | Very high | between layers A and B |
| IE4 | - | yielding of laminate | Very high | between layers A and B |
| IE5 | High | between layers B and C | High | mixed through all layers |

**Preparation of PV minimodules**

For the PV modules comprising the layer elements as described above as integrated backsheet elements 300 mm x 200 mm laminates consisting of Glass/Encapsulant/Cell with connectors/layer element as described above were prepared using a PEnergy L036LAB vacuum laminator.

Glass layer, structured solar glass, low iron glass, supplied by InterFloat, length: 300 mm and width: 200 mm, total thickness of 3.2 mm.

The front protective glass element was cleaned with isopropanol before putting the first encapsulation layer element film on the solar glass. The front encapsulation layer element was cut in the same dimension as the solar glass element. After the front encapsulation layer element was put on the front protective glass element, then the soldered solar cell was put on the front encapsulation layer element. Further the layer element of the invention was put on the obtained PV cell element. The obtained PV module assembly was then subjected to a lamination process as described below.

Table 6: Lamination settings for photovoltaic modules

| Temperature, °C | Pressure, mbar (step (iv) | Heating (i), s | Evacuation (ii), s | Pressure build-up of pressing step (iii), s | Pressure holding sub step of pressing step (iv), s | Total time of steps (i) to (iv), s |
|---|---|---|---|---|---|---|
| 150 | 800 | 0 | 300 | 10 | 900 | 1210 |

As front encapsulants the following compositions were used:

EVA: (Hangzhou EVA F406P): ethyl vinylacetate with 28% vinylacetate and $MFR_2$ = ca. 35 g/10 min
PE-A-b: (0,45mm thick): ethylene terpolymer with methylacrlyate comonomer units and vinyltrimethoxysilane comonomer units i.e. 22.5 wt% MA, 1.4% VTMS and $MFR_2$ = 2.5-3.5 g/10 min.

The same type of structured solar glass having a thickness of 3.2 mm (Ducat) was used for all cells.
The cell used was a P-type mono crystalline silica cell with three buss-bars and having a dimension of 156x156x0.2 mm and with a cell efficiency of 17.80%. The cell was supplied by ITS with a part number of ITS2-02-60MS3B200C-1780B. The composition of the soldering wire was Sn:Pb:Ag (62:36:2).
The vacuum lamination occurred at 150°C using a lamination program of 5 minutes evacuation time, followed by 15 minutes pressing time with an upper chamber pressure of 800 mbar.
The power output (front flash only) for the produced PV modules was tested before and after ageing tests (2000h DH as well as 2000h DH+250 cycles TCT) and reported in Table 6. The related power loss after each ageing test is reported in brackets next to power output. The results for visual inspection and EL imaging after ageing test for these minimodules are reported in Table 7.

Table 7: Power output and power losses on modules before and after DH and TCT ageing tests.

| Mini Module components Encapsulant - LE | Pmax, Watt 0h DH | Pmax, Watt 2000h DH | Pmax, Watt 2000h DH + extra 250 cycles TCT |
|---|---|---|---|
| PE-A-b - CE1 | 4.10 | 4.04 (1.46)* | 3.92 (4.39)* |
| PE-A-b - IE1 | 4.06 | 4.06 (0.00)* | 3.79 (6.65)* |
| PE-A-b - IE2 | 4.05 | 4.04 (0.25)* | 3.88 (4.20)* |
| PE-A-b - IE3 | 4.08 | 4.07 (0.25)* | 3.96 (2.94)* |
| PE-A-b - IE4 | 4.12 | 4.11 (0.24)* | 3.97 (3.64)* |
| PE-A-b - IE5 | 4.13 | 4.13 (0.00)* | 3.98 (3.63)* |
| EVA - CE1 | 4.08 | 4.06 (0.49)* | 3.88 (4.90)* |
| EVA - IE1 | 4.07 | 4.08 (-0.25)* | 3.76 (7.62)* |
| EVA - IE2 | 4.10 | 4.10 (0.00)* | 3.89 (5.12)* |
| EVA - IE3 | 4.09 | 4.08 (0.24)* | 3.72 (9.05)* |
| EVA - IE4 | 4.14 | 4.12 (0.48)* | 3.97 (4.11)* |
| EVA - IE5 | 4.17 | 4.15 (0.48)* | 3.82 (8.39)* |
| power loss in % compared to original value. | | | |

Table 8: Visual inspection (also with EL images) on modules after ageing

| Mini Module components Encapsulant - IBS | Changes on modules after ageing for 2000hrs DH and 250 cycles** in TCT | |
|---|---|---|
| | Delamination | Defects |
| PE-A-b - CE1 | minor | no |
| PE-A-b - IE1 | minor, on edges of the module | Very minor |

(continued)

| Mini Module components | Changes on modules after ageing for 2000hrs DH and 250 cycles** in TCT | |
| Encapsulant - IBS | Delamination | Defects |
|---|---|---|
| PE-A-b - IE2 | no | no |
| PE-A-b - IE3 | no | no |
| PE-A-b - IE4 | no | no |
| PE-A-b - IE5 | no | no |
| EVA - CE1 | no | minor |
| EVA - IE1 | no | Several defects |
| EVA - IE2 | no | minor |
| EVA - IE3 | no | Several defects |
| EVA - IE4 | yes, outside the cell area | several defects, even if less visible in EL |
| EVA - IE5 | yes, under the cell and outside the cell | Several defects |

**Backsheet durability test program**

An additional test program was performed for a backsheet layer alone to evaluate the durability of the composition at a critical TCT test. Compounds with different compositions were compared against PP-C-1, which has already earlier been rated good at TCT test. 250 $\mu$m mono backsheet films of each composition were produced on Dr Collin line setup similar to above using only one extruder and no surface embossing (melt temperatures 210-215°C, chill roll temperature 25°C). Small holes were pressed with cutting tools in MD, TD and in 45° direction to give a starting point for the crack propagation. Afterwards laminates with glass, EVA encapsulant (same as above) and a monolayer backsheet film of the inventive compositions below were produced to evaluate the performace in TCT test. The same lamination conditions were used as described above. Visual inspection was made after 200 cycles TCT test. Reference PP-C-1 sample was rated good (++) showing cracks in most critical corners, but crack propagation less than 2mm long, samples with even less cracks were rated very good (+++), samples with slightly more cracks, were rated ok (+)
In below table 9, the different test compositions are presented (in wt%) and the result evaluation after 200 cycles thermal cycling test.

Table 9: PP-C layer compositions (wt%) and TCT test performance.

| | PP-C-1 | PP-C-3 | PP-C-4 | PP-C-5 |
|---|---|---|---|---|
| Heterophasic copolymer A | 27.2 | 28.5 | 63.6 | 32.5 |
| Heterophasic copolymer B | 40.7 | 42 | - | 45 |
| Talc | 23 | 10 | 10 | 10 |
| Queo 8230 | 8 | 9 | - | 7 |
| Queo 6800 | - | - | 16 | - |
| Additives | 1.1 | 1.1 | 1.1 | 1.1 |
| TiO$_2$ masterbatch | | 10 | 10 | 7 |
| TCT test performance (200 cycles) | ++ | + | +++ | +++ |

Heterophasic copolymer A, as described above on page 52
Heterophasic copolymer B, as described above on page 52
both prepared as described in the example section of WO 2017/071847
Queo 8230 is a copolymer of ethylene and 1-octene (MFR$_2$ 190°C determined according to ISO 1133 = 30.0 g/10 min, density determined according to ISO 1183-1/A = 883 kg/m$^3$) commcercially available from Borealis (AT).
Queo 6800LA is a copolymer of ethylene and 1-octene (MFR$_2$ 190°C determined according to ISO 1133 = 0.5 g/10 min, density determined according to ISO 1183-1/A = 868 kg/m$^3$) commcercially available from Borealis (AT).

**Claims**

1. A layer element, which comprises at least three layers A, B, and C in the configuration A-B-C, wherein

   - layer A comprises a polyethylene composition (PE-A) comprising a copolymer of ethylene, which is selected from

     - a copolymer of ethylene, which bears silane group(s) containing units (PE-A-a); or
     - a copolymer of ethylene with polar comonomer units selected from one or more of $(C_1-C_6)$-alkyl acrylate or $(C_1-C_6)$-alkyl $(C_1-C_6)$-alkylacrylate comonomer units, which additionally bears silane group(s) containing units (PE-A-b),

     whereby, the copolymer of ethylene (PE-A-a) is different from the copolymer of ethylene (PE-A-b);
   - layer B comprises a polyethylene composition (PE-B) comprising a copolymer of ethylene, which is selected from

     - a copolymer of ethylene and comonomer units selected from one or more of alpha-olefins having from 3 to 12 carbon atoms (PE-B-a), which has a density of from 850 kg/m$^3$ to 905 kg/m$^3$, determined according to ISO 1183 on compression moulded plaques; or
     - a copolymer of ethylene and comonomer units selected from one or more of alpha-olefins having from 3 to 12 carbon atoms, which additionally bears silane group(s) containing units (PE-B-b), having a density of from 850 kg/m$^3$ to 905 kg/m$^3$, determined according to ISO 1183 on compression moulded plaques; or
     - a copolymer of ethylene and comonomer unit(s) selected from one or more of alpha-olefins having from 3 to 12 carbon atoms, which additionally bears functional group containing units originating from at least one unsaturated carboxylic acid and/or its anhydrides, metal salts, esters, amides or imides and mixtures thereof (PE-B-c), and has a density of from 850 kg/m$^3$ to 905 kg/m$^3$, determined according to ISO 1183 on compression moulded plaques; and
     - layer C comprises a polypropylene composition (PP-C) comprising a polymer of propylene (PP-C-a),

   wherein layers A and B and layers B and C are in adhering contact with each other.

2. The layer element according to claim 1, wherein the polar comonomer units in the copolymer of ethylene (PE-A-b) are selected from $(C_1-C_6)$-alkyl acrylate comonomer units.

3. The layer element according to claims 1 or 2, wherein the silane group(s) containing units of copolymer of ethylene (PE-A-a) or of copolymer of ethylene (PE-A-b) are hydrolysable unsaturated silane compound(s) represented by the formula (I):

$$R^1SiR^2_qY_{3-q} \qquad (I)$$

   wherein

   $R^1$ is an ethylenically unsaturated hydrocarbyl, hydrocarbyloxy or (meth)acryloxy hydrocarbyl group,
   each $R^2$ is independently an aliphatic saturated hydrocarbyl group,
   Y which may be the same or different, is a hydrolysable organic group and
   q is 0, 1 or 2.

4. The layer element according to any one of claims 1 to 3, wherein the copolymer of ethylene (PE-A-a) and the copolymer of ethylene (PE-A-b) has one or more of the following properties:

   - density of from 920 to 960 kg/m$^3$, determined according to ISO 1183 on compression moulded plaques;
   - melt flow rate MFR$_2$ of from less than 20 g/10 min, determined according to ISO 1133 at a temperature of 190°C and a load of 2.16 kg;
   - melting temperature Tm of from 70 to 120°C, determined as described in WO 2018/141672; and/or
   - shear thinning index SHI$_{0.05/300}$ of from 30.0 to 100.0, determined by dynamic shear measurements as described in WO 2018/141672.

5. The layer element according to any one of claims 1 to 4, wherein the copolymer of ethylene (PE-B-a) is a copolymer of ethylene and 1-butene, a copolymer of ethylene and 1-hexene or a copolymer of ethylene and 1-octene;

the copolymer of ethylene (PE-B-b) is a copolymer of ethylene and 1-butene, a copolymer of ethylene and 1-hexene or a copolymer of ethylene and 1-octene onto which silane group(s) containing units are grafted; and the copolymer of ethylene (PE-B-c) is a copolymer of ethylene and 1-butene, a copolymer of ethylene and 1-hexene or a copolymer of ethylene and 1-octene onto which functional groups containing units originating from maleic anhydride, acrylic acid, methacrylic acid, crotonic acid, fumaric acid, fumaric acid anhydride, maleic acid, citraconic acid and mixtures thereof are grafted.

6. The layer element according to any one of claims 1 to 5, wherein the silane group(s) containing unit(s) of copolymer of ethylene (PE-B-b) is/are hydrolysable unsaturated silane compound(s) represented by the formula (I):

$$R^1SiR^2_qY_{3-q} \qquad (I)$$

wherein

$R^1$ is an ethylenically unsaturated hydrocarbyl, hydrocarbyloxy or (meth)acryloxy hydrocarbyl group,
each $R^2$ is independently an aliphatic saturated hydrocarbyl group,
Y which may be the same or different, is a hydrolysable organic group and
q is 0, 1 or 2.

7. The layer element according to any one of claims 1 to 6, wherein the copolymer of ethylene (PE-B-a), (PE-B-b) or (PE-B-c) has a melt flow rate $MFR_2$ of less than 20 g/min, determined according to ISO 1133 at a temperature of 190°C and a load of 2.16 kg.

8. The layer element according to any one of claims 1 to 7, wherein the polypropylene composition (PP-C) comprises a heterophasic copolymer of propylene, which comprises,

- a polypropylene matrix component and
- an elastomeric propylene copolymer component which is dispersed in said polypropylene matrix.

9. The layer element according to claim 8, wherein the heterophasic copolymer of propylene has one or more of the following properties:

- Melting temperature Tm of at least 145°C, determined as described in WO 2018/141672;
- Vicat softening temperature Vicat A of at least 90°C, determined according to ASTM D1525 method A (50°C/h, 10N);
- Melt flow rate $MFR_2$ of 1.0 to 20.0 g/10 min, determined according to ISO 1133 at a temperature of 230°C and a load of 2.16 kg;
- Xylene cold soluble (XCS) fraction in amount of from 5 to 40 wt%, determined as described in WO 2018/141672;
- Comonomer content of 2.0.0 to 20.0 wt%, determined according to WO 2017/071847;
- Flexural modulus of at least 600 MPa, determined as described in WO 2017/071847; and/or
- Density of 900 to 910 kg/m$^3$, determined according to ISO 1183 on compression moulded plaques.

10. The layer element according to any one of claims 1 to 9, wherein the thickness ratio of the layers A : B : C in a three-layer element ranges from 45 : 10 : 45 to 33.3 : 33.3 : 33.3 or the thickness ratio of the layers X : A : B : C : Y in a five-layer element ranges from 20 : 25 : 10 : 25 : 20 to 20 : 20 : 20 : 20 :20.

11. The layer element according to any one of claims 1 to 10, wherein the layer element has a total thickness of from 325 $\mu$m to 2000 $\mu$m.

12. An article comprising the layer element according to any one of claims 1 to 11, preferably being a photovoltaic module comprising a photovoltaic element and the layer element, wherein the photovoltaic element is in adhering contact with layer A of the layer element, more preferably being a photovoltaic module, which comprises, in the given order, a protective front layer element, a front encapsulation layer element, a photovoltaic element and an integrated backsheet element, wherein the integrated backsheet element comprises, preferably consists of the layer element (LE).

13. A process for producing the layer element according to any one of claims 1 to 11 comprising the steps of:

   - adhering the layers A, B and C of the layer element together by extrusion or lamination in the configuration A-B-C; and
   - recovering the formed layer element.

14. A process for producing an article, being a photovoltaic (PV) module according to claim 12 comprising the steps of:

   - assembling the photovoltaic element, the layer element and optional further layer elements to a photovoltaic (PV) module assembly;
   - laminating the layer elements of the photovoltaic (PV) module assembly in elevated temperature to adhere the elements together; and
   - recovering the obtained photovoltaic (PV) module.

15. The use of the layer element according to any one of claims 1 to 11 as an integrated backsheet element of a photovoltaic module comprising a photovoltaic element and said layer element, wherein the photovoltaic element is in adhering contact with layer A of the layer element.

**Patentansprüche**

1. Ein Schichtelement, das mindestens drei Schichten A, B und C in der Konfiguration AB-C umfasst, wobei

   - Schicht A eine Polyethylen-Zusammensetzung (PE-A) umfasst, die ein Ethylen-Copolymer umfasst, das ausgewählt ist aus

      - einem Ethylen-Copolymer, das Silangruppe(n) enthaltende Einheiten (PE-A-a) trägt; oder
      - einem Copolymer aus Ethylen mit polaren Comonomereinheiten, ausgewählt aus einer oder mehreren $(C_1 - C_6)$-Alkylacrylat- oder $(C_1 - C_6)$-Alkyl $(C_1 - C_6)$-Alkylacrylat-Comonomereinheiten, das zusätzlich Silangruppe(n) enthaltende Einheiten (PE-A-b) trägt,

      wobei das Ethylen-Copolymer (PE-A-a) von dem Ethylen-Copolymer (PE-A-b) verschieden ist;
   - Schicht B eine Polyethylen-Zusammensetzung (PE-B) umfasst, die ein Ethylen-Copolymer umfasst, das ausgewählt ist aus

      - einem Copolymer aus Ethylen und Comonomereinheiten, ausgewählt aus einem oder mehreren alpha-Olefinen mit 3 bis 12 Kohlenstoffatomen (PE-B-a), das eine Dichte von 850 $kg/m^3$ bis 905 $kg/m^3$, bestimmt nach ISO 1183 an formgepressten Platten, besitzt; oder
      - ein Copolymer aus Ethylen und Comonomereinheiten, ausgewählt aus einem oder mehreren alpha-Olefinen mit 3 bis 12 Kohlenstoffatomen, das zusätzlich Silangruppe(n) enthaltende Einheiten (PE-B-b) trägt, mit einer Dichte von 850 $kg/m^3$ bis 905 $kg/m^3$, bestimmt nach ISO 1183 an formgepressten Platten; oder
      - ein Copolymer aus Ethylen und Comonomereinheit(en), ausgewählt aus einem oder mehreren alpha-Olefinen mit 3 bis 12 Kohlenstoffatomen, das zusätzlich funktionelle Gruppen enthaltende Einheiten trägt, die von mindestens einer ungesättigten Carbonsäure und/oder ihren Anhydriden, Metallsalzen, Estern, Amiden oder Imiden und deren Mischungen (PE-B-c) stammen, und eine Dichte von 850 $kg/m^3$ bis 905 $kg/m^3$, bestimmt nach ISO 1183 an formgepressten Platten, besitzt; und
      - Schicht C eine Polypropylen-Zusammensetzung (PP-C) umfasst, die ein Propylenpolymer (PP-C-a) umfasst,

   wobei die Schichten A und B und die Schichten B und C in Haftkontakt zueinander stehen.

2. Das Schichtelement nach Anspruch 1, wobei die polaren Comonomereinheiten in dem Ethylen-Copolymer (PE-A-b) aus $(C_1 - C_6)$-Alkylacrylat-Comonomereinheiten ausgewählt sind.

3. Das Schichtelement nach Anspruch 1 oder 2, wobei die Silangruppe(n) enthaltenden Einheiten des Ethylen-Copolymers (PE-A-a) oder des Ethylen-Copolymers (PE-A-b) hydrolysierbare ungesättigte Silanverbindung(en) der Formel (I) sind:

EP 3 915 782 B1

$$R^1 SiR^2_q Y_{3-q} \qquad (I)$$

wobei

R$^1$ eine ethylenisch ungesättigte Hydrocarbyl-, Hydrocarbyloxy- oder (Meth)acryloxy-Hydrocarbylgruppe ist,
jedes R$^2$ unabhängig eine aliphatische, gesättigte Kohlenwasserstoffgruppe ist,
Y, welches gleich oder verschieden sein kann, eine hydrolysierbare organische Gruppe ist und
q 0, 1 oder 2 ist.

4.  Das Schichtelement nach einem der Ansprüche 1 bis 3, wobei das Ethylen-Copolymer (PE-A-a) und das Ethylen-Copolymer (PE-A-b) eine oder mehrere der folgenden Eigenschaften aufweist:

    - Dichte von 920 bis 960 kg/m$^3$, bestimmt nach ISO 1183 an formgepressten Platten;
    - Schmelzflussrate MFR$_2$ von weniger als 20 g/10 min, bestimmt nach ISO 1133 bei einer Temperatur von 190°C und einer Last von 2,16 kg;
    - Schmelztemperatur Tm von 70 bis 120 °C, bestimmt wie in WO 2018/141672 beschrieben; und/oder
    - Strukturviskositätsindex SHI$_{0,05/300}$ von 30,0 bis 100,0, bestimmt durch dynamische Schermessungen wie in WO 2018/141672 beschrieben.

5.  Das Schichtelement nach einem der Ansprüche 1 bis 4, wobei das Ethylen-Copolymer (PE-B-a) ein Copolymer aus Ethylen und 1-Buten, ein Copolymer aus Ethylen und 1-Hexen oder ein Copolymer aus Ethylen und 1-Octen ist;

    das Ethylen-Copolymer (PE-B-b) ein Copolymer aus Ethylen und 1-Buten, ein Copolymer aus Ethylen und 1-Hexen oder ein Copolymer aus Ethylen und 1-Octen ist, auf das Silangruppe(n) enthaltende Einheiten aufgepfropft sind; und
    das Ethylen-Copolymer (PE-B-c) ein Copolymer aus Ethylen und 1-Buten, ein Copolymer aus Ethylen und 1-Hexen oder ein Copolymer aus Ethylen und 1-Octen ist, auf das funktionelle Gruppen enthaltende Einheiten aufgepfropft sind, die von Maleinsäureanhydrid, Acrylsäure, Methacrylsäure, Crotonsäure, Fumarsäure, Fumarsäureanhydrid, Maleinsäure, Citraconsäure und deren Mischungen stammen.

6.  Das Schichtelement nach einem der Ansprüche 1 bis 5, wobei die Silangruppe(n) enthaltende Einheit(en) des Ethylen-Copolymers (PE-B-b) hydrolysierbare ungesättigte Silanverbindung(en) der Formel (I) ist/sind:

$$R^1 SiR^2_q Y_{3-q} \qquad (I)$$

wobei

R$^1$ eine ethylenisch ungesättigte Hydrocarbyl-, Hydrocarbyloxy- oder (Meth)acryloxy-Hydrocarbylgruppe ist,
jedes R$^2$ unabhängig eine aliphatische, gesättigte Kohlenwasserstoffgruppe ist,
Y, welches gleich oder verschieden sein kann, eine hydrolysierbare organische Gruppe ist und
q 0, 1 oder 2 ist.

7.  Das Schichtelement nach einem der Ansprüche 1 bis 6, wobei das Ethylen-Copolymer (PE-B-a), (PE-B-b) oder (PE-B-c) eine Schmelzflussrate MFR$_2$ von weniger als 20 g/min aufweist, bestimmt nach ISO 1133 bei einer Temperatur von 190°C und einer Last von 2,16 kg.

8.  Das Schichtelement nach einem der Ansprüche 1 bis 7, wobei die Polypropylen Zusammensetzung (PP-C) ein heterophasisches Propylen-Copolymer umfasst, das

    - eine Polypropylen-Matrixkomponente und
    - eine elastomere Propylen-Copolymer-Komponente, die in der Polypropylen-Matrix dispergiert ist,

    umfasst.

9.  Das Schichtelement nach Anspruch 8, wobei das heterophasische Propylen-Copolymer eine oder mehrere der folgenden Eigenschaften aufweist:

    - Schmelztemperatur Tm von mindestens 145 °C, bestimmt wie in WO 2018/141672 beschrieben;

- Vicat-Erweichungstemperatur Vicat A von mindestens 90 °C, bestimmt nach ASTM D1525 Methode A (50 °C/h, 10 N);
- Schmelzflussrate MFR$_2$ von 1,0 bis 20,0 g/10 min, bestimmt nach ISO 1133 bei einer Temperatur von 230°C und einer Last von 2,16 kg;
- Xylol kaltlösliche (XCS) Fraktion in einer Menge von 5 bis 40 Gew.-%, bestimmt wie in WO 2018/141672 beschrieben;
- Comonomergehalt von 2,0 bis 20,0 Gew.-%, bestimmt nach WO 2017/071847;
- Biegemodul von mindestens 600 MPa, bestimmt wie in WO 2017/071847 beschrieben; und/oder
- Dichte von 900 bis 910 kg/m$^3$, bestimmt nach ISO 1183 an formgepressten Platten.

10. Das Schichtelement nach einem der Ansprüche 1 bis 9, wobei das Dickenverhältnis der Schichten A : B : C in einem dreischichtigen Element im Bereich von 45 : 10 : 45 bis 33,3 : 33,3 : 33,3 oder das Dickenverhältnis der Schichten X : A : B : C : Y in einem fünfschichtigen Element im Bereich von 20 : 25 : 10 : 25 : 20 bis 20 : 20 : 20 : 20 : 20 :20 liegt.

11. Das Schichtelement nach einem der Ansprüche 1 bis 10, wobei das Schichtelement eine Gesamtdicke von 325 μm bis 2000 μm aufweist.

12. Ein Gegenstand, der das Schichtelement nach einem der Ansprüche 1 bis 11 umfasst, wobei es sich vorzugsweise um ein photovoltaisches Modul handelt, das ein photovoltaisches Element und das Schichtelement umfasst, wobei das photovoltaische Element in haftendem Kontakt mit der Schicht A des Schichtelements steht, wobei es sich noch bevorzugter um ein photovoltaisches Modul handelt, das in der angegebenen Reihenfolge ein schützendes Frontschichtelement, ein Frontverkapselungsschichtelement, ein photovoltaisches Element und ein integriertes Rückschichtelement umfasst, wobei das integrierte Rückschichtelement das Schichtelement (LE) umfasst, vorzugsweise daraus besteht.

13. Ein Verfahren zur Herstellung des Schichtelements nach einem der Ansprüche 1 bis 11, das die folgenden Schritte umfasst:

- Zusammenkleben der Schichten A, B und C des Schichtelements durch Extrusion oder Laminierung in der Konfiguration A-B-C; und
- Rückgewinnen des geformten Schichtelements.

14. Ein Verfahren zur Herstellung eines Gegenstands, bei dem es sich um ein photovoltaisches (PV) Modul nach Anspruch 12 handelt, das die folgenden Schritte umfasst:

- Zusammenbau des photovoltaischen Elements, des Schichtelements und optional weiterer Schichtelemente zu einer photovoltaischen (PV) Modulanordnung;
- Laminieren der Schichtelemente der photovoltaischen (PV) Modulanordnung bei erhöhter Temperatur, um die Elemente miteinander zu verkleben; und
- Rückgewinnen des erhaltenen Photovoltaik-Moduls (PV).

15. Eine Verwendung des Schichtelements nach einem der Ansprüche 1 bis 11 als integriertes Rückschichtelement eines photovoltaischen Moduls, das ein photovoltaisches Element und das besagte Schichtelement umfasst, wobei das photovoltaische Element in Haftkontakt mit der Schicht A des Schichtelements steht.

**Revendications**

1. Élément en couches, qui comprend au moins trois couches A, B et C dans la configuration A-B-C, dans lequel

- la couche A comprend une composition de polyéthylène (PE-A) comprenant un copolymère d'éthylène, qui est choisi parmi
- un copolymère d'éthylène, qui porte des motifs contenant un(des) groupe(s) silane (PE-A-a) ; ou
- un copolymère d'éthylène avec des motifs comonomères polaires sélectionnés parmi un ou plusieurs motifs comonomères acrylate d'alkyle en $C_1$-$C_6$ ou (alkyle en $C_1$-$C_6$)-acrylate d'alkyle en $C_1$-$C_6$, qui porte en plus des motifs contenant un(des) groupe(s) silane (PE-A-b), le copolymère d'éthylène (PE-A-a) étant différent du copolymère d'éthylène (PE-A-b) ;
- la couche B comprend une composition de polyéthylène (PE-B) comprenant un copolymère d'éthylène, qui est choisi parmi

- un copolymère d'éthylène et de motifs comonomères sélectionnés parmi une ou plusieurs alpha-oléfines ayant de 3 à 12 atomes de carbone (PE-B-a), qui présente une masse volumique de 850 kg/m$^3$ à 905 kg/m$^3$, déterminée selon la norme ISO 1183 sur des plaques moulées par compression ; ou

- un copolymère d'éthylène et de motifs comonomères sélectionnés parmi une ou plusieurs alpha-oléfines ayant de 3 à 12 atomes de carbone, qui porte en plus des motifs contenant un(des) groupes silane (PE-B-b), présentant une masse volumique de 850 kg/m$^3$ à 905 kg/m$^3$, déterminée selon la norme ISO 1183 sur des plaques moulées par compression ; ou

- un copolymère d'éthylène et d'un ou de plusieurs motif(s) comonomère(s) sélectionné(s) parmi une ou plusieurs alpha-oléfines ayant de 3 à 12 atomes de carbone, qui porte en plus des motifs contenant un groupe fonctionnel provenant d'au moins un acide carboxylique insaturé et/ou de ses anhydrides, sels métalliques, esters, amides ou imides et des mélanges de ceux-ci (PE-B-c), et présente une masse volumique de 850 kg/m$^3$ à 905 kg/m$^3$, déterminée selon la norme ISO 1183 sur des plaques moulées par compression ; et

- la couche C comprend une composition de polypropylène (PP-C) comprenant un polymère de propylène (PP-C-a),

dans lequel les couches A et B et les couches B et C sont en contact adhérent les unes avec les autres.

2. Élément en couches selon la revendication 1, dans lequel les motifs comonomères polaires dans le copolymère d'éthylène (PE-A-b) sont sélectionnés parmi les motifs comonomères acrylate d'alkyle en $C_1$-$C_6$.

3. Élément en couches selon les revendications 1 ou 2, dans lequel les motifs contenant un(des) groupes silane du copolymère d'éthylène (PE-A-a) ou du copolymère d'éthylène (PE-A-b) sont un(des) composé(s) de silane insaturé(s) hydrolysable(s) représenté(s) par la formule (I) :

$$R^1 SiR^2_q Y_{3-q} \qquad (I)$$

dans laquelle

R$^1$ est un groupe hydrocarbyle, hydrocarbyloxy ou (méth)acryloxy hydrocarbyle à insaturation éthylénique, chaque R$^2$ est indépendamment un groupe hydrocarbyle aliphatique saturé,
les Y, qui peuvent être identiques ou différents, sont un groupe organique hydrolysable et q est 0, 1 ou 2.

4. Élément en couches selon l'une des revendications 1 à 3, dans lequel le copolymère d'éthylène (PE-A-a) et le copolymère d'éthylène (PE-A-b) présentent une ou plusieurs des propriétés suivantes :

- masse volumique de 920 à 960 kg/m$^3$, déterminée selon la norme ISO 1183 sur des plaques moulées par compression ;
- indice de fluidité à chaud MFR2 inférieur à 20 g/10 min, déterminé selon la norme ISO 1133 à une température de 190 °C et une charge de 2,16 kg ;
- température de fusion Tm de 70 à 120 °C, déterminée comme décrit dans WO 2018/141672 ; et/ou
- indice de fluidification par cisaillement SHI$_{0,05/300}$ de 30,0 à 100,0, déterminé par des mesures de cisaillement dynamique comme décrit dans WO 2018/141672.

5. Élément en couches selon l'une des revendications 1 à 4, dans lequel le copolymère d'éthylène (PE-B-a) est un copolymère d'éthylène et de 1-butène, un copolymère d'éthylène et de 1-hexène ou un copolymère d'éthylène et de 1-octène ;

le copolymère d'éthylène (PE-B-b) est un copolymère d'éthylène et de 1-butène, un copolymère d'éthylène et de 1-hexène ou un copolymère d'éthylène et de 1-octène sur lequel sont greffés des motifs contenant un(des) groupe(s) silane ; et
le copolymère d'éthylène (PE-B-c) est un copolymère d'éthylène et de 1-butène, un copolymère d'éthylène et de 1-hexène ou un copolymère d'éthylène et de 1-octène sur lequel sont greffés des motifs contenant des groupes fonctionnels provenant de l'anhydride maléique, de l'acide acrylique, de l'acide méthacrylique, de l'acide crotonique, de l'acide fumarique, de l'anhydride d'acide fumarique, de l'acide maléique, de l'acide citraconique et des mélanges de ceux-ci.

6. Élément en couches selon l'une des revendications 1 à 5, dans lequel le(les) motifs contenant un(des) groupes silane du copolymère d'éthylène (PE-A-b) est/sont un(des) composé(s) de silane insaturé(s) hydrolysable(s) représenté(s) par la formule (I) :

$$R^1SiR^2_qY_{3-q} \qquad (I)$$

dans laquelle

R$^1$ est un groupe hydrocarbyle, hydrocarbyloxy ou (méth)acryloxy hydrocarbyle à insaturation éthylénique,
chaque R$^2$ est indépendamment un groupe hydrocarbyle aliphatique saturé,
les Y, qui peuvent être identiques ou différents, sont un groupe organique hydrolysable et q est 0, 1 ou 2.

7. Élément en couches selon l'une des revendications 1 à 6, dans lequel le copolymère d'éthylène (PE-B-a), (PE-B-b) ou (PE-B-c) présente un indice de fluidité à chaud MFR$_2$ inférieur à 20 g/min, déterminé selon la norme ISO 1133 à une température de 190 °C et une charge de 2,16 kg.

8. Élément en couches selon l'une des revendications 1 à 7, dans lequel la composition de polypropylène (PP-C) comprend un copolymère hétérophasique de propylène, qui comprend,

   - un composant de matrice en polypropylène et
   - un composant élastomère en copolymère de propylène qui est dispersé dans ladite matrice en polypropylène.

9. Élément en couches selon la revendication 8, dans lequel le copolymère hétérophasique de propylène présente une ou plusieurs des propriétés suivantes :

   - température de fusion Tm d'au moins 145 °C, déterminée comme décrit dans WO 2018/141672 ;
   - température Vicat de ramollissement Vicat A d'au moins 90 °C, déterminée selon le procédé ASTM D1525 A (50 °C/h, 10 N) ;
   - indice de fluidité à chaud MFR2 de 1,0 à 20,0 g/10 min, déterminé selon la norme ISO 1133 à une température de 230 °C et une charge de 2,16 kg ;
   - fraction soluble dans le xylène froid (XCS) en une quantité de 5 à 40 % en poids, déterminée comme décrit dans WO 2018/141672 ;
   - teneur en comonomère de 2,0 à 20,0 % en poids, déterminée selon WO 2017/071847 ;
   - module de flexion d'au moins 600 MPa, déterminé comme décrit dans WO 2017/071847 ; et/ou
   - masse volumique de 900 à 910 kg/m$^3$, déterminée selon la norme ISO 1183 sur des plaques moulées par compression.

10. Élément en couches selon l'une des revendications 1 à 9, dans lequel le rapport d'épaisseur des couches A : B : C dans un élément à trois couches est de 45 : 10 : 45 à 33,3 : 33,3 : 33,3 ou le rapport d'épaisseur des couches X : A : B : C : Y dans un élément à cinq couches est de 20 : 25 : 10 : 25 : 20 à 20 : 20 : 20 : 20 : 20.

11. Élément en couches selon l'une des revendications 1 à 10, dans lequel l'élément en couches présente une épaisseur totale de 325 um à 2000 $\mu$m.

12. Article comprenant l'élément en couches selon l'une des revendications 1 à 11, qui est de préférence un module photovoltaïque comprenant un élément photovoltaïque et l'élément en couches, dans lequel l'élément photovoltaïque est en contact adhérent avec la couche A de l'élément en couches, de manière davantage préférée qui est un module photovoltaïque qui comprend, dans l'ordre donné, un élément en couches avant de protection, un élément en couches avant d'encapsulation, un élément photovoltaïque et un élément de feuille arrière intégré, dans lequel l'élément de feuille arrière intégré comprend, de préférence constitué en, l'élément en couches (LE).

13. Procédé de production de l'élément en couches selon l'une des revendications 1 à 11 comprenant les étapes suivantes :

   - l'adhérence des couches A, B et C de l'élément en couches ensemble par extrusion ou stratification dans la configuration A-B-C ; et
   - la récupération de l'élément en couches formé.

14. Procédé de production d'un article, qui est un module photovoltaïque (PV) selon la revendication 12, comprenant les étapes suivantes :

- l'assemblage de l'élément photovoltaïque, de l'élément en couches et d'éléments en couches optionnels supplémentaires en un ensemble module photovoltaïque (PV) ;
- la stratification des éléments en couches de l'ensemble module photovoltaïque (PV) à température élevée pour faire adhérer les éléments ensemble ; et
- la récupération du module photovoltaïque (PV) obtenu.

15. Utilisation de l'élément en couches selon l'une des revendications 1 à 11 comme élément de feuille arrière intégré d'un module photovoltaïque comprenant un élément photovoltaïque et ledit élément en couches, dans laquelle l'élément photovoltaïque est en contact adhérent avec la couche A de l'élément en couches.

Fig 1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2018141672 A
- US 20190123226 A1
- WO 2019134904 A
- WO 2017071847 A
- EP 0887379 A
- WO 9212182 A
- WO 2004000899 A
- WO 2004111095 A
- WO 9924478 A
- WO 9924479 A
- WO 0068315 A
- WO 8707620 A
- WO 9221705 A
- WO 9311165 A
- WO 9311166 A
- WO 9319100 A
- WO 9736939 A
- WO 9812234 A
- WO 9933842 A
- WO 03000756 A
- WO 03000757 A
- WO 03000754 A
- WO 03000755 A
- WO 2004029112 A
- EP 2610271 A
- WO 2012007430 A
- WO 9219659 A
- WO 9219653 A
- WO 9219658 A
- US 4382019 A
- US 4435550 A
- US 4465782 A
- US 4473660 A
- US 4560671 A
- US 5539067 A
- US 5618771 A
- EP 45975 A
- EP 45976 A
- EP 45977 A
- WO 9532994 A
- US 4107414 A
- US 4186107 A
- US 4226963 A
- US 4347160 A
- US 4472524 A
- US 4522930 A
- US 4530912 A
- US 4532313 A
- US 4657882 A
- US 4581342 A
- WO 2019201934 A

**Non-patent literature cited in the description**

- Plastic Additives Handbook. Hans Zweifel, 2001